(19) **Europäisches Patentamt**
**European Patent Office**
**Office européen des brevets**

(11) **EP 4 576 155 A1**

(12) **EUROPEAN PATENT APPLICATION**

(43) Date of publication:
**25.06.2025 Bulletin 2025/26**

(21) Application number: **23217694.1**

(22) Date of filing: **18.12.2023**

(51) International Patent Classification (IPC):
***H01J 37/153*** (2006.01)

(52) Cooperative Patent Classification (CPC):
**H01J 37/153**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ASML Netherlands B.V.**
**5500 AH Veldhoven (NL)**

(72) Inventor: **WIELAND, Marco, Jan-Jaco**
**5500 AH Veldhoven (NL)**

(74) Representative: **ASML Netherlands B.V.**
**Corporate Intellectual Property**
**P.O. Box 324**
**5500 AH Veldhoven (NL)**

(54) **CHARGED PARTICLE-OPTICAL DEVICE, CHARGED PARTICLE-OPTICAL MODULE, METHOD OF PROJECTING A PLURALITY OF CHARGED PARTICLE BEAMS TOWARDS A SAMPLE**

(57) The disclosure relates to apparatus and methods for projecting a plurality of charged particle beams towards a sample, and particularly for projecting the beams with reduced aberrations. In one arrangement, a charged particle-optical device comprises a lens array configured to focus a plurality of beams in a beam grid towards a sample position. A corrector comprises at least two aperture arrays having aperture patterns, including one or more pairs of facing aperture surfaces. Each pair corresponds to a species of correction for a respective aberration of the beam grid. A voltage supply is configured to apply a potential difference between the or each pair of facing aperture surfaces to cause the respective species of correction to be applied, the applied potential difference selectable to define a magnitude of the respective species of correction substantially independently of focusing of the beam grid at a sample position.

## Fig. 12

**EP 4 576 155 A1**

## Description

### FIELD

The disclosure relates to apparatus and methods for projecting a plurality of charged particle beams towards a sample, and particularly for projecting the beams with reduced aberrations.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, which may be referred to as samples, for example to detect pattern defects. These tools typically use electron microscopy techniques, such as a scanning electron microscope (SEM). In a SEM, a primary electron beam of electrons at a relatively high energy is targeted with a final deceleration step to land on a sample at a relatively low landing energy. The beam of electrons is focused as a probing spot on the sample. The interactions between the material structure at the probing spot and the landing electrons from the beam of electrons cause signal electrons to be emitted from the surface, such as secondary electrons, backscattered electrons or Auger electrons. The signal electrons may be emitted from the material structure of the sample. By scanning the primary electron beam as the probing spot over the sample surface, signal electrons can be emitted across the surface of the sample. By collecting these emitted signal electrons from the sample surface, a pattern inspection tool may obtain an image representing characteristics of the material structure of the surface of the sample.

Electron-optical devices may be provided with correction features that reduce aberrations. The correction features may be, for example, variations in the shapes, sizes and/or positions of apertures of aperture arrays defined in plates through which the electron beams pass. Such apertures of the aperture arrays may be nominally uniform, having at least similar shape and size and be positioned at grid points of a nominally regular array. The correction features may consist of adjustments in shapes (e.g. ellipticity), sizes and/or positions of the apertures relative to the nominally uniform array. The correction features may be referred to as hardcoded corrections or passive corrections. Such hardcoded corrections cannot readily be changed and may not be optimal in all situations.

Increased flexibility for correction can be achieved by allowing voltages to lenses to be controlled on an individual beam-to-beam basis, but this increases complexity of operation and can be difficult to implement where there are a large number of beams due to limited space availability. It would be desirable to provide alternative or improved arrangements for controlling the properties of charged particle beams.

### SUMMARY

It is an object of the present disclosure to improve control of charged particle beams.

According to an aspect of the invention, there is provided a charged particle-optical device comprising: a lens array configured to focus a plurality of charged particle beams in a beam grid towards a sample position; a corrector comprising at least two aperture arrays in which are defined corresponding arrays of apertures each having an aperture pattern, the at least two aperture arrays comprising one or more pairs of facing aperture surfaces of adjacent aperture arrays, each pair of facing aperture surfaces corresponding to a species of correction for a respective aberration of the beam grid, the aperture pattern defined in at least one of the facing aperture surfaces of the pair being configured to apply the respective species of correction to the beam grid; and a voltage supply configured to apply a potential difference between the or each pair of facing aperture surfaces to cause the respective species of correction to be applied to the beams of the beam grid, the applied potential difference selectable to define a magnitude of the respective species of correction substantially independently of focusing of the beam grid at a sample position.

According to an aspect of the invention, there is provided a method of projecting a plurality of charged particle beams towards a sample, comprising: using a lens array to focus a plurality of charged particle beams in a beam grid towards a sample; applying a potential difference between a pair of facing aperture surfaces of a corrector to apply a species of correction to the beam grid, the species of correction defined by an aperture pattern, wherein: the magnitude of the applied species of correction is selectable independently of focusing of the beam grid on the sample.

According to an aspect of the invention, there is provided a charged particle-optical module for a charged particle-optical device, the module comprising: a lens array configured to focus a plurality of charged particle beams in a beam grid towards a sample position; and a corrector comprising at least two aperture arrays in which are defined corresponding arrays of apertures each having an aperture pattern, the at least two aperture arrays comprising one or more pairs of facing aperture surfaces of adjacent aperture arrays, each pair of facing aperture surfaces corresponding to a species of correction for a respective aberration of the beam grid, the aperture pattern defined in at least one of the surfaces of the pair being configured to apply the respective species of correction to the beam grid, wherein:

the module is configured such that a potential difference applied between the or each pair of facing aperture surfaces will cause the respective species of correction to be applied to the beams of the beam grid, and the applied potential difference is selectable to define a magnitude of the respective species of correction substantially independently of focusing of the beam grid at a sample position.

According to an aspect of the invention, there is provided a charged particle-optical module for a charged particle-optical device, the module comprising: a lens array configured to focus a plurality of charged particle beams in a beam grid towards a sample position; and a corrector comprising at least two aperture arrays in which are defined corresponding arrays of apertures each having an aperture pattern, the at least two aperture arrays comprising one or more pairs of facing aperture surfaces of adjacent aperture arrays, each pair of facing aperture surfaces corresponding to a species of correction for a respective aberration of the beam grid, the aperture pattern defined in at least one of the surfaces of the pair being configured to apply the respective species of correction to the beam grid, wherein:

the module is configured such that control of a potential difference applied between the or each pair of facing aperture surfaces to apply respective species of correction enables operation of the lens array to allow adjustment of beam current and/or landing energy of the beams of the beam grid at the sample while the applied species of correction compensate for macro aberrations contributed by the adjustment of beam current and/or landing energy.

According to an aspect of the invention, there is provided a corrector for applying a correction to a beam grid projected to a sample position, the corrector comprising: at least two aperture arrays along a path of the beam grid so that adjacent aperture arrays have a pair of facing aperture surfaces corresponding to a species of correction for a respective aberration of the beam grid, apertures in one or both of surfaces of the pair of the aperture surfaces having a fingerprint corresponding to the species of correction, wherein the magnitude of the individual species of correction applied to the beam grid is selectable by adjusting a single control potential applied between the facing aperture surfaces substantially independently of focusing the beam grid at a sample position.

According to an aspect of the invention, there is provided an electron-optical module for an electron-optical column for projecting a beam grid towards a sample, the module comprising: a lens array of lenses configured to project a beam grid towards a sample; a corrector for applying a correction to the beam grid, the corrector comprising: at least two aperture arrays along a path of the beam grid so that adjacent aperture arrays have a pair of facing aperture surfaces corresponding to a species of correction for a respective aberration of the beam grid, apertures in one or both of surfaces of the pair of facing aperture surfaces have a fingerprint corresponding to the species of correction, wherein the magnitude of the individual species of correction applied to the beam grid is selectable by adjusting a single control potential applied between the facing aperture surfaces and the corrector applies the species of correction substantially independently of operation of the lens array on the beam grid.

According to an aspect of the invention, there is provided an electron-optical module for an electron-optical column for projecting a beam grid towards a sample, the module comprising: a lens array of lenses configured to project a beam grid towards a sample; a corrector for applying a correction to the beam grid, the corrector comprising: at least two aperture arrays along a path of the beam grid so that adjacent aperture arrays have a pair of facing aperture surfaces corresponding to [a/at least one] species of correction for a respective aberration of the beam grid, apertures in one or both of surfaces of the pair of facing aperture surfaces have a fingerprint corresponding to the species of correction, wherein control of a difference applied to the corrector enables operation of the lens array is configured to controlled by selection of landing energy and beam current so that adjustment of the landing energy for resolution adjustment is independent of adjustment of magnification for adjusting beam current of the beam grid.

BRIEF DESCRIPTION OF FIGURES

The above and other aspects of the present disclosure will become more apparent from the description of exemplary embodiments, taken in conjunction with the accompanying drawings.

FIG. 1 is a schematic diagram illustrating an exemplary assessment apparatus.

FIG. 2 is a schematic diagram illustrating an exemplary multi-beam apparatus that is part of the exemplary assessment apparatus of **FIG. 1.**

FIG. 3 is a schematic diagram of an exemplary charged particle-optical device comprising a collimator element array and a scan-deflector array.

FIG. 4 is a schematic diagram of an exemplary charged particle-optical device array comprising charged particle-optical devices of **FIG. 3.**

FIG. 5 is a schematic diagram of an exemplary charged particle-optical device comprising a condenser lens array.

FIG. 6 is a top view of a portion of a plate defining an aperture array having apertures with a range of different aperture areas for compensating for off-axis aberrations such as field curvature.

FIG. 7 is a top view of a portion of a plate defining an aperture array having apertures with a range of different ellipticities for compensating for off-axis aberrations such as astigmatism.

**FIG. 8** is a top view of a portion of a plate defining an aperture array having apertures that are displaced with respect to nominal positions to compensate for off-axis aberrations such as distortion caused by telecentricity error.

**FIG. 9** is a schematic side view of an exemplary objective lens assembly.

**FIG. 10** is a graph of beam current versus resolution showing curves of minimized resolution for two different landing energies, and additionally showing curves in which landing energy is stepped from 2.5keV to 1keV with fixed image plane and at minimized resolution for each of eight different physical configurations of the system.

**FIG. 11** is the graph of **FIG. 10** with a curve of stepped landing energy at fixed image plane position being shown for one of the physical configurations of the charged particle-optical device (i.e. one set of hardcoded corrections) and with additional curves showing variation of beam current achieved by controlling demagnification (by controlling potentials applied to plates of an objective lens assembly).

**FIG. 12** is a schematic side view of a portion of a charged particle-optical device comprising a corrector (or a corrector array with a different corrector element for each beam path).

**FIG. 13-14** are graphs depicting results of simulations showing performance of a charged particle-optical device.

**FIG. 15** is a schematic side view of a portion of a charged particle-optical device comprising a corrector and a deflector array.

**FIG. 16** is a graph of beam current versus resolution showing curves of minimized resolution for three different landing energies, and additionally showing data points showing use of a corrector to optimize resolution while beam current is varied for each of the three landing energies.

**FIG. 17** is a schematic side view of a portion of a charged particle-optical device comprising a corrector, a deflector array, and control lens array.

**FIG. 18** is a schematic side view of a variation on the device of **FIG. 17** in which the control lens array is provided on an upbeam side of the corrector.

**FIG. 19** and **20** are variations on the device of **FIG. 15** in which the corrector comprises multiple pairs of facing aperture surfaces.

## DETAILED DESCRIPTION

The reduction of the physical size of devices, and enhancement of the computing power of devices, may be accomplished by increasing the packing density of circuit components such as transistors, capacitors, diodes, etc. on an IC chip. This has been enabled by increased spatial resolution of semiconductor IC manufacturing processes. Semiconductor IC manufacturing is a complex and time-consuming process, with hundreds of individual steps. An error in any step of the process of manufacturing an IC chip has the potential to adversely affect the functioning of the final product. Just one defect could cause device failure. It is desirable to improve the overall yield of the process. For example, to obtain a 75% yield for a 50-step process (where a step may indicate the number of layers formed on a wafer), each individual step must have a yield greater than 99.4%. If an individual step has a yield of 95%, the overall process yield would be as low as 7-8%.

Maintaining a high substrate (i.e. wafer) throughput, defined as the number of substrates processed per hour, is also desirable. High process yield and high substrate throughput may be impacted by the presence of a defect. This is especially true if operator intervention is required for reviewing the defects. High throughput detection and identification of micro and nano-scale defects by assessment systems (such as a Scanning Electron Microscope ('SEM')) is desirable for maintaining high yield and low cost for IC chips.

A scanning electron microscope comprises a scanning device and a detector apparatus. The scanning device comprises an illumination apparatus that comprises an electron source, for generating primary electrons, and a projection apparatus for scanning a target, such as a substrate, with one or more focused beams of primary electrons. The primary electrons interact with the target and generate interaction products, such as signal particles e.g. secondary electrons and/or backscattered electrons. Secondary electrons may be considered to have an energy of up to 50eV. Backscatter electrons, although having an energy spectrum from substantially zero to the energy of the maximum of the charged particle device, are conventionally set to electrons (or signal electrons) having an energy exceeding 50eV. The detection apparatus captures the signal particles (e.g. secondary electrons and/or backscattered electrons) from the target as the target is scanned so that the scanning electron microscope may create an image of the scanned area of the target. A design of charged particle-optical apparatus embodying these scanning electron microscope features may have a single beam. For higher throughput such as for assessment, some designs of apparatus use multiple focused beams of primary electrons. The multiple focused beams may be referred to as a multi-beam or beam grid. These terms are used interchangeably herein. The component beams of the multi-beam may be referred to as sub-beams, beamlets, or beams. A multi-beam may scan different parts of a target simultaneously. A multi-beam assessment apparatus may therefore assess a target much quicker, e.g. by moving the target at a higher speed, than a single-beam assessment apparatus.

An implementation of a known multi-beam assessment apparatus is described below.

The Figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to in reference to electrons, throughout the present document may therefore be more generally considered to be references to charged particles, and items referred to in reference to charged particles, with the charged particles not necessarily being electrons.

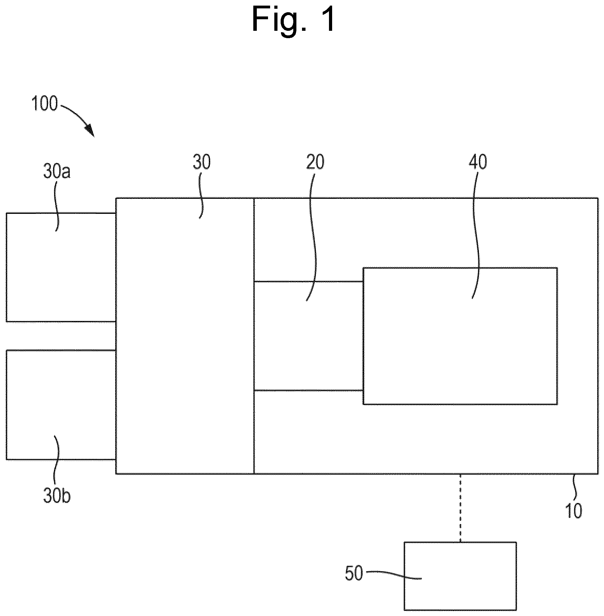

Reference is now made to **FIG. 1,** which is a schematic diagram illustrating an exemplary assessment apparatus 100, or inspection apparatus. The assessment apparatus 100 of **FIG. 1** includes a vacuum chamber 10, a load lock chamber 20, a charged particle-optical apparatus, an equipment front end module (EFEM) 30 and a controller 50. The apparatus 100 may comprise a charged particle-optical device 40 (also known as an electron-optical device, an electron beam device or an electron beam device) and a motorized or actuated stage. The charged particle-optical device 40 may be within the vacuum chamber 10.

The EFEM 30 includes a first loading port 30a and a second loading port 30b. The EFEM 30 may include additional loading port(s). The first loading port 30a and second loading port 30b may, for example, receive substrate front opening unified pods (FOUPs) that contain substrates (e.g., semiconductor substrates or substrates made of other material(s)) or targets to be assessed (substrates, wafers and samples are collectively referred to as "targets" hereafter). One or more robot arms (not shown) in EFEM 30 transport the targets to load lock chamber 20.

The load lock chamber 20 is used to remove the gas around a target. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. The main chamber 10 is connected to a main chamber vacuum pump system (not shown). The main chamber vacuum pump system removes gas molecules in the main chamber 10 so that the pressure around the target reaches a second pressure lower than the first pressure. After reaching the second pressure, the target is transported to the charged particle-optical device 40 by which it may be assessed. A charged particle-optical device 40 may comprise either a single beam or a multi-beam charged particle-optical apparatus.

The controller 50 is electronically connected to the charged particle-optical device 40. The controller 50 may be a processor (such as a computer) configured to control the charged particle beam assessment apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam assessment apparatus or it may be distributed over at least two of the component elements. While the present disclosure provides examples of main chamber 10 housing an electron beam assessment apparatus, it should be noted that aspects of the disclosure in their broadest sense are not limited to a chamber housing a charged particle-optical device. Rather, it is appreciated that the foregoing principles may also be applied to other apparatuses and other arrangements of apparatus that operate under the second pressure.

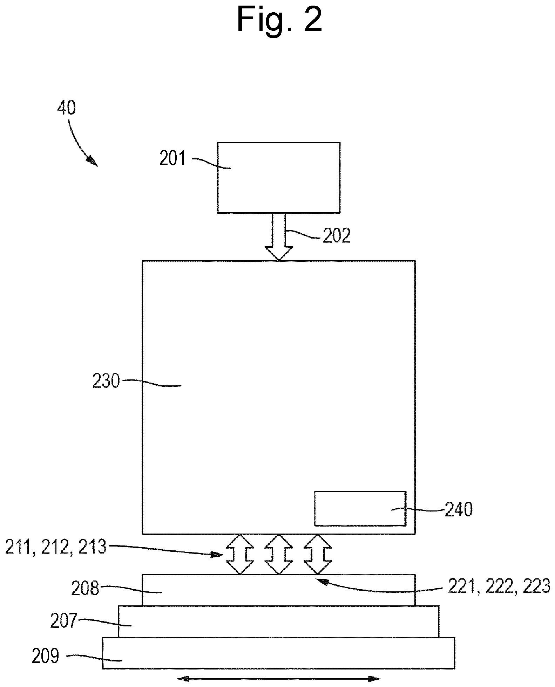

Reference is now made to **FIG. 2,** which is a schematic diagram illustrating an exemplary charged particle-optical device 40 that may be provided as part of the exemplary assessment apparatus 100 of **FIG. 1.** Charged particle-optical device 40 comprises an electron source 201, a projection apparatus 230, a motorized stage 209, and a sample holder 207. The electron source 201 and projection apparatus 230 may together be referred to as an illumination apparatus. The sample holder 207 is supported by motorized or actuated stage 209 so as to hold a sample 208 (e.g., a substrate or a mask) for inspection. Charged particle-optical device 40 further comprises an electron detection device 240.

Electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form a primary electron beam 202.

Projection apparatus 230 is configured to convert primary electron beam 202 into a plurality of beams 211, 212, 213 and to direct each beam onto the sample 208. Although three beams are illustrated for simplicity, there may be many tens, many hundreds, many thousands, many tens of thousands, or even hundreds of thousands (or more) of beams. The beams may be referred to as sub-beams, beamlets, or beams.

Controller 50 may be connected to various parts of the assessment apparatus 100 of **FIG. 1,** such as electron source 201, electron detection device 240, projection apparatus 230, and motorized stage 209. Controller 50 may perform various image and signal processing functions. Controller 50 may also generate various control signals to govern operations of the assessment apparatus.

Projection apparatus 230 may be configured to focus beams 211, 212, and 213 onto a sample 208 for inspection and may form three probe spots 221, 222, and 223 on the surface of sample 208. Projection apparatus 230 may be configured to deflect primary beams 211, 212, and 213 to scan probe spots 221, 222, and 223 across individual scanning areas in a section of the surface of sample 208. In response to incidence of primary beams 211, 212, and 213 on probe spots 221, 222, and 223 on sample 208, electrons are generated from the sample 208 which include secondary electrons and backscattered electrons which may be referred to as signal particles. The secondary electrons typically have electron energy < 50 eV and backscattered electrons typically have electron energy between 50 eV and the landing energy of primary beams 211, 212, and 213.

Electron detection device 240 is configured to detect secondary electrons and/or backscattered electrons and to generate corresponding signals which are sent to controller 50 or a signal processing system (not shown), e.g. to construct images of the corresponding scanned areas of sample 208. Electron detection device may be incorporated into the projection apparatus or may be separate therefrom, with a secondary optical column being provided to direct secondary electrons and/or backscattered electrons to the electron detection device.

The controller 50 may comprise image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to an electron detection device 240 of the device 40 permitting signal communication, such as an electrical conductor, optical fiber cable, portable storage media, IR, Bluetooth, internet, wireless network, wireless radio, among others, or a combination thereof. The image acquirer may receive a signal from electron detection device 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage device may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

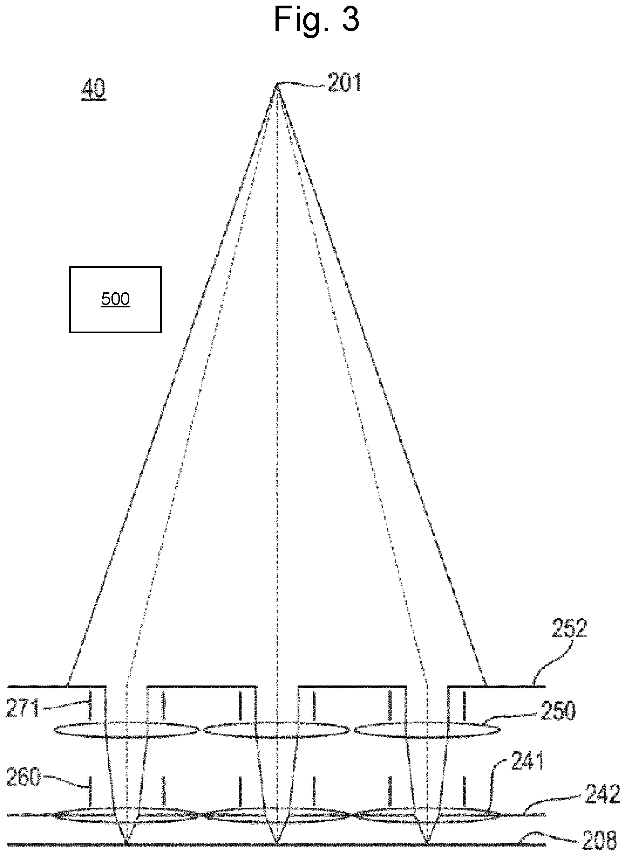

FIG. 3 is a schematic diagram of an example charged particle-optical device 40. The charged particle-optical device 40 may comprise a source 201 and one or more electron-optical assemblies. Alternatively, the electron-optical apparatus that comprises the charged particle-optical device 40 may comprise the source 201. The charged particle-optical device 40 may comprise an upper beam limiter 252, a collimator element array 271, a control lens array 250, a scan deflector array 260, an objective lens array 241, a beam shaping limiter 242 and a detector array. The source 201 provides a beam of charged particles (e.g. electrons).

The upper beam limiter 252 defines an array of beam-limiting apertures. The upper beam limiter 252 may comprise a plate (which may be a plate-like body) having a plurality of apertures. The upper beam limiter 252 forms a plurality of beams from the beam of charged particles emitted by the source 201, which may be referred to as a multi-beam or a beam grid. Portions of the beam other than those contributing to forming the plurality of beams may be blocked (e.g. absorbed) by the upper beam limiter 252 so as not to interfere with the beams down-beam.

The collimator element array 271 is provided downbeam of the upper beam limiter 252. Each collimator element collimates a respective beam (e.g., sub-beam). The collimator element array 271 may be formed using MEMS manufacturing techniques to be spatially compact. In some embodiments, exemplified in FIG. 3, the collimator element array 271 is the first deflecting or focusing charged particle-optical array element in the beam path downbeam of the source 201. In another arrangement, the collimator may take the form, wholly or partially, of a macro-collimator. Such a macro-collimator may be upbeam of the upper beam limiter 252 so it operates on the beam from the source before generation of the multi-beam. A magnetic lens may be used as the macro-collimator. The macro collimator may use a combination of magnetic and electrostatic lenses.

The control lens array 250 is located downbeam of the collimator element array 271. The control lens array 250 comprises a plurality of control lenses. Each control lens comprises at least two electrodes (e.g. two or three electrodes) connected to respective potential sources. The electrodes may be referred to as plates or aperture arrays. The control lens array 250 may comprise two or more (e.g. three) plate electrode arrays connected to respective potential sources. The control lens array 250 may be associated with the objective lens array 241 (e.g. the two arrays may be positioned close to each other and/or mechanically connected to each other and/or controlled together as a unit).

The control lens array 250 may be considered as providing electrodes additional to the electrodes 242, 243 of the objective lens array 241 for example as part of an objective lens assembly. The additional electrodes of the control lens array 250 allow further degrees of freedom for controlling charged particle-optical parameters of the beams in the multi-beam. For example, the control lens array 250 may be used to optimize a beam opening angle with respect to the demagnification of the beam and/or to control the beam energy delivered to the objective lens array 241. If there are two electrodes in the control lens array 250 then the demagnification and landing energy are controlled together. If there are three or more electrodes in the control lens array 250 the demagnification and landing energy can be controlled independently. The control lenses may thus be configured to adjust the demagnification and/or beam opening angle of respective beams.

In an embodiment the control lens array 250 may be considered to be additional electrodes of the objective lens array 241 enabling additional functionality of the respective objective lenses of the objective lens array 241. In an arrangement such electrodes may be considered part of the objective lens array providing additional functionality to the objective lenses of the objective lens array 241. In such an arrangement, the control lens is considered to be part of the corresponding objective lens, even to the extent that the control lens is only referred to as being a part of the objective lens for example in terms of providing one or more extra degrees of freedom to the objective lens. Although the control lens array 241 may be indistinct from and part of the objective lens array 250, in this description the control lens array 250 is considered to be distinct and separate from the objective lens array 241.

For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. As described above, lens arrays may instead comprise multiple plates with apertures.

The scan-deflector array 260 comprising a plurality of scan deflectors may be provided. The scan-deflector array 260 may be formed using MEMS manufacturing techniques. Each scan deflector scans a respective beam of the multi-beam over the sample 208. In an embodiment, the scanning deflectors described in EP2425444, which document is hereby incorporated by reference in its entirety specifically in relation to scan deflectors, may be used to implement the scan-deflector array 260. In another embodiment, a macro scan deflector is provided instead of, or in addition to, the scan-deflector array 260. The macro scan deflector may be provided between a macro collimator and the control lens array 250. The macro scan deflector may act macroscopically on all of a beam from the source 201 rather than comprising an array of deflector elements that are each configured to act on a different individual portion of the beam or on a different beam of a multi-beam (or beam grid).

The objective lens array 241 comprises a plurality of objective lenses for directing the beams of the multi-beam onto the sample 208. Each objective lens comprises at least two electrodes (e.g. two or three electrodes) connected to respective potential sources. The electrodes may be referred to as plates or aperture arrays.

The objective lens array may form part of an objective lens assembly along with any or all of the scan-deflector array 260, control lens array 250 and collimator element array 271. The objective lens assembly may further comprise the beam shaping limiter 242. The beam shaping limiter 242 defines an array of beam-limiting apertures.

In an arrangement, the beam shaping limiter 242 is structurally integrated with an electrode of the objective lens array 241. Desirably, the beam shaping limiter 242 is positioned in a region of low electrostatic field strength. Each of the beam-limiting apertures is aligned with a corresponding objective lens in the objective lens array 241.

In an embodiment, the charged particle-optical device 40 is configured to control the objective lens assembly (e.g. by controlling potentials applied to electrodes of the control lens array 250) so that a focal length of the control lenses is larger than a separation between the control lens array 250 and the objective lens array 241. The control lens array 250 and objective lens array 241 may thus be positioned relatively close together, with a focusing action from the control lens array 250 that is too weak to form an intermediate focus between the control lens array 250 and objective lens array 241. The control lens array and the objective lens array operate together to define a combined focal length to the same surface. Combined operation without an intermediate focus may reduce the risk of aberrations. In other embodiments, the objective lens assembly may be configured to form an intermediate focus between the control lens array 250 and the objective lens array 241.

An electric power source, for example a voltage supply, may be provided to apply respective potentials to electrodes of the control lenses of the control lens array 250 and the objective lenses of the objective lens array 241.

The detector array (not shown) is provided to detect charged particles emitted from the sample 208. The detected charged particles may include any of the charged particles (e.g. signal particles) detected by a scanning electron microscope, including secondary (e.g. emitted) and/or backscattered electrons from the sample 208. The detector may be an array providing the surface of the charged particle-optical device facing the sample 208, e.g. the bottom surface of the charged particle-optical device. Alternatively (or additionally) the detector array be upbeam of the bottom surface, for example in or upbeam of the objective lens array or the control lens array. The elements of the detector array may correspond to the beams of the multi-beam. The signal generated by detection of an electron by an element of the array may be transmitted to a controller (e.g., controller 50) for generation of an image. The signal may correspond to a pixel of an image.

In other embodiments both a macro scan deflector and the scan-deflector array 260 are provided. In such an arrangement, the scanning of the beams of the multi-beam over the sample surface may be achieved by controlling the macro scan deflector and the scan-deflector array 260 together, preferably in synchronization.

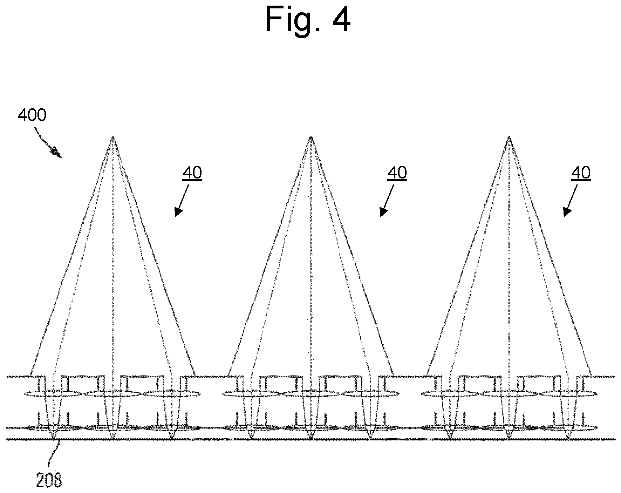

In an embodiment, as exemplified in **FIG. 4,** a charged particle-optical device array 400 is provided. The array 400 may comprise a plurality of any of the charged particle-optical devices described herein. Each of the charged particle-optical devices focuses a plurality of charged particle beams from a beam of charged particles emitted by a different respective source. A plurality of sources may thus be provided. The charged particle-optical devices are arranged to focus respective pluralities of charged particle beams (which may be referred to as multi-beams or beam grids) onto different regions of the same sample, for example simultaneously. In the example of **FIG. 4** the array 400 comprises a plurality of charged particle-optical devices of the type described above with reference to **FIG. 3.**

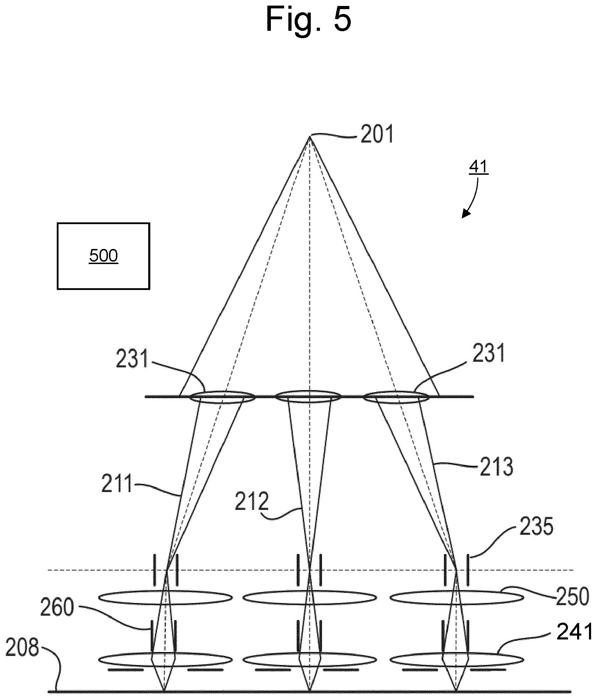

**FIG. 5** depicts an alternative configuration of charged particle-optical device 40, which may have the same features as described with respect to **FIG. 3** except as described below and illustrated in **FIG. 5.** The alternative configuration may comprise a condenser lens array 231 upbeam of the objective lens array 241, as disclosed in EP 3869535A1, which is hereby incorporated by reference so far as the description of the multi-beam device with a collimator and its components.

Each condenser lens in the condenser lens array 231 directs charged particles into a respective beam 211, 212, 213 which is focused at a respective intermediate focus. A collimator or an array of collimators may be positioned to operate on the respective intermediate foci. The collimators may take the form of deflectors 235 provided at the intermediate foci. Collimators e.g. deflectors 235 are configured to bend a respective beam 211, 212, 213 by an amount effective to ensure that the principal ray (which may also be referred to as the beam axis) is incident on the sample 208 substantially normally (i.e. at substantially 90° to the nominal surface of the sample).

In some arrangements, apertures in the objective lens array 241 are adapted (or 'hardcoded') to compensate for off-axis aberrations in the beams of the beam grid, and/or across the multibeam of the beam grid. Such off-axis aberrations may be field curvature, distortion (or telecentricity error) and/or astigmatism. (It should be noted that in this context for the hardcoded corrections for distortion to take effect, the objective lens array 241 is understood to comprise the control lens array 250). For example, the apertures of one or more of the objective electrodes may be shaped, sized and/or positioned to compensation for the off-axis aberrations. The apertures may, for example, have a range of different areas (or a range of diameters) to compensate for field curvature, a range of different ellipticities to compensate for astigmatism, and/or a range of different displacements from nominal grid positions to compensate for distortion caused by telecentricity error. See for example WO2022/101072A1, which is hereby incorporated by reference so far as off-axis aberration correction.

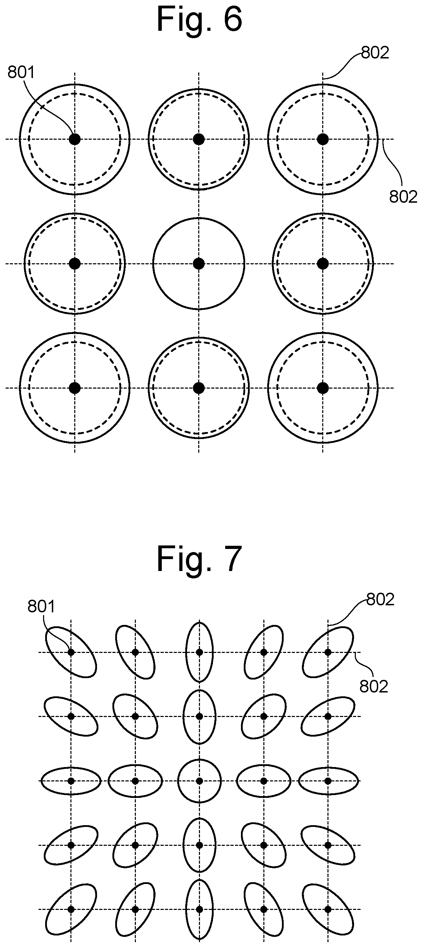

**FIG. 6** depicts an example arrangement of apertures in an aperture array having different areas to compensate for off-axis aberrations such as field curvature. At least a subset of the apertures have a range of different aperture areas. The variations in aperture area depicted in **FIG. 6** are exaggerated for clarity and will in practice be smaller than depicted. The solid line circles represent the apertures having a range of different aperture areas. The broken line circles represent unmodified aperture sizes to assist with visual recognition of the depicted variations in aperture area. The different aperture areas may be described by reference to the diameter of a circle that would have the same aperture area. Thus, aperture areas may be described by reference to a diameter even if the corresponding apertures are not exactly circular. The variations will often involve increases in aperture area as a function of increasing distance from a principal axis of the multi-beam (as depicted schematically in **FIG. 6,** with the principal axis being perpendicular to the page and passing through the centermost aperture). It is also possible for appropriate corrections to involve decreases in aperture area as a function of increasing distance from a principal axis of the multi-beam. In the example shown in **FIG. 6,** the apertures are arranged on a regular grid defined by grid points 801 and grid lines 802.

**FIG. 7** depicts an example arrangement of apertures in an aperture array having a range of ellipticities to compensate for off-axis aberrations such as astigmatism. At least a subset of the apertures have a range of different ellipticities. The variations in ellipticity depicted in **FIG. 7** are exaggerated for clarity and will in practice be smaller than depicted. The range of different ellipticities are selected to compensate for off-axis aberrations such as astigmatism. The variations may involve increases in the size of radially oriented axes, which may be major axes, of apertures as a function of increasing distance from a principal axis of the multi-beam (as depicted schematically in **FIG. 7** with the principal axis being perpendicular to the page and passing through the centermost aperture). It is also possible for appropriate correction to involve increases in the size of azimuthally oriented axes, which may be major axes, of apertures as a function of increasing distance from the principal axis of the multi-beam. In the example shown in **FIG. 7,** the apertures are arranged on a regular grid defined by grid points 801 and grid lines 802.

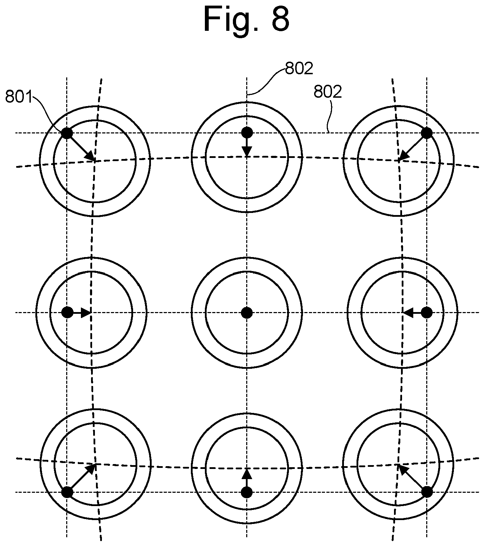

**FIG. 8** depicts an example arrangement of apertures in an aperture array having a range of different displacements from nominal grid positions to compensate for off-axis aberrations such as distortion caused by telecentricity error. At least a subset of the apertures are displaced relative to nominal positions. Such nominal positions may correspond to the intersection between grid lines 802 of a grid. The apertures are each displaced with respect to a corresponding nominal position 801 on the grid. The nominal positions may be provided on a regular grid. The regular grid may comprise a rectangular, square, or hexagonal grid for example. The nominal positions may represent positions corresponding to an ideal configuration in which there are no off-axis aberrations. The displacements depicted in **FIG. 8** are exaggerated for clarity and will in practice be smaller than depicted. The displacements cause the apertures to lie on a grid (depicted by thick broken lines) that is distorted relative to the nominal grid (depicted by grid lines 802). The off-axis aberrations compensated for by the displacements may comprise distortion caused by telecentricity error. The displacements may be radially inwards as exemplified in **FIG. 8** (towards a principal axis of the multi-beam) or radially outwards. In both cases, the size of the displacements may increase with radial distance. In the simplified example of **FIG. 8** this leads to the corner apertures being displaced more than the side apertures.

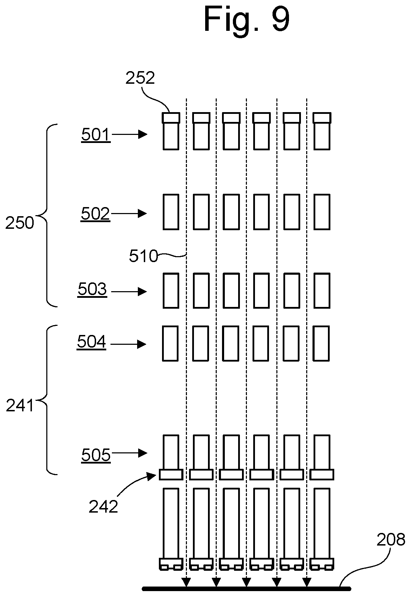

**FIG. 9** depicts a portion of an exemplary objective lens assembly in further detail. The objective lens assembly could be used in any of the charged particle-optical devices 40 disclosed herein, including those discussed above with reference to **FIG. 3-5.** The lens array assembly comprises a series of electrodes 501 to 505 (which may be referred to as plates or aperture arrays) positioned orthogonal to and/or in series along the beam paths of the beam grid. In this example, the objective lens assembly comprises a control lens array 250 and an objective lens array 241. Each electrode 501, 502, 503 that contributes to the control lens array may comprise a plate defining an aperture for each beam path 510. The objective lens array 241 may be defined by a plurality of electrodes 504, 505. Each electrode 504, 505 that contributes to the objective lens array 241 may comprise a plate defining an aperture for each beam path 510.

Five exemplary sub-beam paths 510 are shown in **FIG. 9.** The electrodes 501 to 503 are arranged in series along the beam paths 510 and define respective apertures aligned with the beam paths 510 to define the control lenses. Each control lens is thus aligned with a beam path 510 of a respective beam and operates on (e.g. electrostatically manipulates) the beam. The electrodes 504 and 505 are also arranged in series along the beam paths 510 and define respective apertures aligned with the beam paths 510 to define the objective lenses. Each objective lens in the objective lens array 241 may be aligned with a beam path 510 aligned with a respective control lens. The objective lens array 241 directs the beams onto the sample 208.

In operation, charged particle-optical devices generate strong electric fields between electrodes (e.g., plates or aperture arrays) of the objective lens array 241. Significant electric fields may also be generated between electrodes elsewhere in the system. Strong electric fields are associated with correspondingly strong electrostatic pressures. Electrostatic pressure is proportional to the field energy density, $\eta_E$, which in turn is proportional to $E^2$ according to $\eta_E = \frac{1}{2}\varepsilon E^2$ (where $\varepsilon$ is the electric permittivity and $E$ is the electric field strength). The electrostatic pressure thus increases quickly with increasing $E$.

In some arrangements, the electrostatic pressure causes a change in shape and/or position of one or more of the electrodes. Such change in shape and/or position may be referred to as field-induced mechanical distortion. Typically, electrodes may bow into regions high electric field strength. This mode of electrode distortion (mechanical distortion of an electrode) may be referred to as bow. Bow may cause distortion having a parabolic or approximately parabolic form; that is, the distortion varies as an approximate function of the square of radial position.

Electrode distortion in the objective lens array 241 may affect beams of the multi-beam (beam grid). The electrode distortion may contribute to field curvature for example. Field curvature is where the focus plane is different for different beams of the multi-beam, which may lead to focus errors at a planar surface of the sample 208. It is possible to configure the objective lens array to compensate for a predicted effect on the beams from a predicted electrode distortion in the objective lens array. The objective lens array may thus be provided with a hardcoded correction (which may be referred to as a hardware correction). The objective lens array may operate as a passive corrector array (or a corrector for the beam grid as whole). In some arrangements, the hardcoded correction comprises variations in sizes (e.g., diameters such as where the apertures are circular) of apertures defined in one or more of the electrodes as a function of position in each electrode. Varying the sizes of apertures in the electrodes can compensate for changes in field curvature.

Finite manufacturing tolerances limit the accuracy of electrode distortion prediction (or prediction of mechanical distortion of a plate electrode). Hardcoded corrections of the type described above may not achieve optimal compensation for this reason. Tuning landing energy may also lead to significant changes in the electrostatic field in the objective lens array, which may again lead to hardcoded corrections being inadequate. Arrangements described below aim to improve compensation of an effect of electrode distortion (or mechanical distortion). The improved compensation may allow manufacturing tolerances to be relaxed (e.g. from 1% to 10%) and/or to support tunable landing energy functionality. Arrangements are described below that allow landing energy to be varied while simultaneously suppressing both field curvature and astigmatism.

Electrodes or plates defining aperture arrays (e.g., including a control lens array 250 and/or an objective lens array 241 and/or a corrector 601) may be configured to perform various functions as described below.

These functions may be performed by controlling the electrodes, for example by controlling potentials applied to the electrodes. A voltage supply 500 may be provided for this purpose. As described below, the voltage supply 500 may be configured to perform control functionality. The control functionality may be computer-implemented, with any suitable combination of elements (e.g. CPUs, RAM, etc.) being used to provide the required functionality. As described above with reference to **FIG. 5,** the control electrodes and objective electrodes may be controlled by connecting the electrodes to potential sources. The controller 500 may thus comprise and/or control the potential sources that apply potentials to the different lens electrodes.

Any reference herein to a device or system being configured to perform functionality is intended to encompass the case where the voltage supply 500 and/or other physical hardware is configured to perform the functionality (e.g., by being suitably programmed to provide the necessary control signals to apparatus such as one or more potential sources).

In some arrangements, a charged particle-optical device 40 is configured to implement a plurality of selectable landing energies for a beam (optionally for all of the beams) of a beam grid. The plurality of selectable landing energies may be implemented by applying corresponding potentials to electrodes of a control lens array 250 and/or an objective lens array 241. Different potentials may be applied for each selectable landing energy. The device thus allows different landing energies to be selected for a beam at different corresponding times. The selectable landing energies may comprise one or more continuous ranges of landing energies. In this case, the device would be able to select any landing energy within the one or more continuous ranges. Alternatively or additionally, the selectable landing energies may comprise a plurality of predetermined discrete landing energies. The selection may be performed by a user. The device may thus receive user input (e.g. via a user interface of a computer system or as an input data stream) and select a selectable landing energy based at least partially (i.e. wholly or partly) on the received user input. Alternatively or additionally, the device may operate at least partially (i.e. wholly or partly) automatically. The device may for example select landing energies based at least partially on a predefined program or in response to one or more input parameters, for example determined by an application or model. The input parameters may represent measurements made by the system for example.

The selection of a landing energy may depend on the particular inspection scenario. For example, the landing energy may be selected to optimize for a parameter of a certain type of signal particle such as secondary electron yield and contrast (which may be defined as the yield difference between a feature and the background). The landing energy that achieves this will be a function of the material being inspected. The nature of the defect of interest may also play a role. Where physical defects are of interest, the material properties will determine secondary electron yield. Where voltage contrast defects are of interest, the charging behavior and therefore secondary electron yield will depend on whether the circuit is able to drain charge. Alternatively or additionally, the landing energy may be selected to control charging (which has an influence on telecentricity error (distortion) as well as secondary electron yield). Alternatively or additionally, the landing energy may be selected to achieve a desired electron-optical performance. For example, a deterioration of resolution caused by selecting a lower landing energy may be traded off against an improvement in secondary electron yield.

In some arrangements, the device is configured to apply a different potential to an electrode of the objective lens array 241 that is furthest from the sample 208 (e.g., objective electrode 504 in **FIG. 9**) for each of at least a portion of the selectable landing energies. Each potential may, for example, be selected to provide the same distance between the objective electrode 504 and an image plane of the system. The potential applied to the objective electrode 504 determines the field strength of the electric field in the objective lens array 241 and, therefore, the focal length of each objective lens. It is therefore possible to control the position of the image plane by controlling the potential applied to the objective electrode 504.

In some arrangements, the device is configured to control the landing energy (i.e., to select a desired landing energy from a range of available selectable landing energies) by controlling at least a potential applied to an objective electrode 505 of the objective lens array 241 that is closest to the sample 208. For example, the objective electrode 505 may be set to a potential corresponding to a beam energy equal to the desired landing energy + a predetermined offset. The offset is used to set the electric field strength at the sample surface. The electric field strength plays a role in determining secondary electron contrast, especially for voltage contrast use cases. Where secondary electrons are to be detected, the offset voltage may typically be about 50V or higher to ensure adequate detection efficiency, although lower offset voltages may be adequate if the distance between a detector and the sample is sufficiently small. A negative voltage is used if it is desired to repel the secondary electrons, for example if one is interested in the back scatter signal.

In some arrangements, the device is configured to control the control lens array 250 to minimize resolution for each of the plurality of selectable landing energies. This may be achieved at least partly by adjusting the control lens array 250 at each selectable landing energy to keep the demagnification of the device (from electron source to sample) divided by the angular demagnification of the device the same for each of the selectable landing energies. This may be achieved, for example, by controlling a potential applied to an intermediate, preferably middle, control electrode 502 of the control lens array 250 (e.g., where the control lens array 250 comprises three electrodes or another odd number of electrodes). Controlling the potential applied to an intermediate, preferably the middle, control electrode 502 of the control lens array 250 controls the demagnification. Keeping the demagnification divided by angular demagnification the same for the different landing energies ensures that off-axis aberrations remain constant. Hardcoded corrections for the off-axis aberrations therefore remain valid, thereby keeping net aberrations (after the corrections) low for the different landing energies. This is achieved without needing to exchange respective objective electrodes or the objective lens array 241, which may undesirably introduce down-time and/or inconvenience. It further obviates or reduces the need for having electron components as an exchangeable module that are field replaceable. Thus may reduce the complexity required of the vacuum chamber.

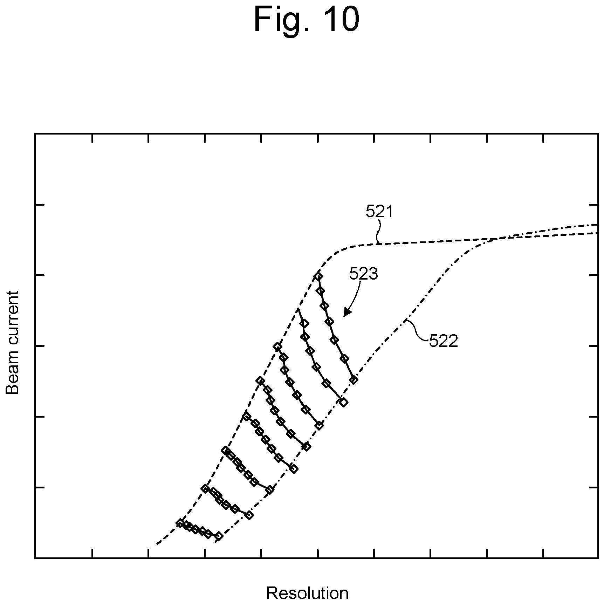

**FIG. 10** is a graph showing predicted variation of beam current of the beams of the multi-beam against beam resolution at the sample 208 for a system using a charged particle-optical device without a condenser lens array, for example featuring a macro-condenser lens and/or another macro charged-particle-optical component such as a macro collimator. The curves are obtained by simulating the electrostatic field and ray tracing electrons through the field. Curve 521 corresponds to a landing energy of 2.5keV. Curve 522 corresponds to a landing energy of 1keV. For each of the curves 521 and 522, each distinct point on the curve represents a distinct physical configuration of the charged-particle device that is optimized for the respective combination of beam current and resolution (including, for example, hard coded off-axis compensations). It is normally desirable for the total current to be high to achieve good throughput and for the resolution to be minimized to provide measurements with good spatial resolution. The graph shows that a balance needs to be achieved between the two quantities: increasing the beam current increases the resolution and vice versa. The curve of beam current against resolution is furthermore different for the different landing energies.

**FIG. 10** also shows eight example curves (solid line curves 523 with open squares) illustrating selection of different landing energies in eight different physical configurations of the charged particle-optical device. For each configuration, represented by a respective one of the curves 523, plural different landing energies are selected between the landing energy of 2.5keV corresponding to curve 521 and the landing energy of 1keV corresponding to curve 522 in steps of 250eV. At each selected landing energy, the charged particle-optical system controls the control lens array 250 to minimize resolution by changing the demagnification. This may be achieved, for example, by keeping the demagnification of the charged particle-optical device divided by angular demagnification of the charged particle-optical device constant to ensure the hard coded off-axis aberration compensations remain valid and/or by varying the demagnification of the control lens array 250 to compensate for other effects such as changes in field curvature caused by mechanical distortion of elements (e.g. electrodes) caused by the electric fields. In each case, potentials applied to electrodes of the control lens array 250 and/or the objective lens array 241 were selected to maintain the same spatial relationship between an image plane and all of the control electrodes and objective electrodes. Each curve 523 thus shows a range of different landing energies and corresponding beam currents and minimized resolution that are made available.

In some arrangements, in contrast to the situation exemplified in **FIG. 10,** the resolution is deliberately not minimized. The removal of this restriction allows a range of different beam currents to be selected for each selectable landing beam energy. Thus, instead of being restricted to having the beam current correspond to one of the curves 523 in **FIG. 10,** the beam current can take other values. Higher beam currents may be selected at the expense of larger (less optimal) resolution. By allowing the beam current to be varied in this manner, the electron-optical system thus provides a plurality of selectable beam currents for each of one or more of the selectable landing beam energies. Thus, in exchange for operating at a larger resolution the beam current may be selected from a range of selectable beam currents at a selected landing beam energy.

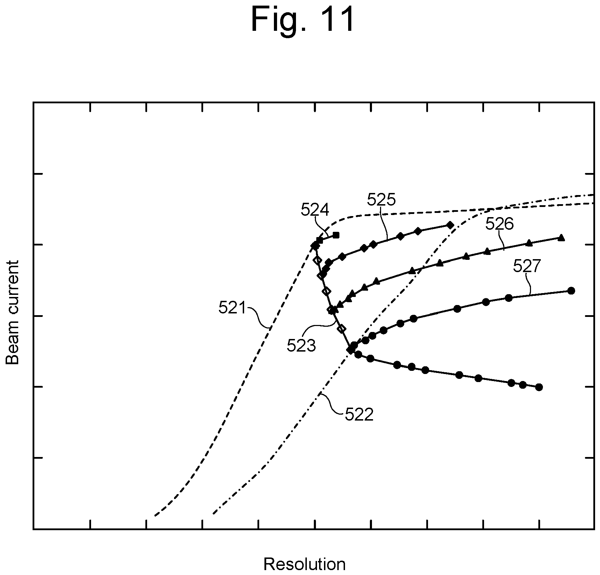

**FIG. 11** is a graph showing four example curves (solid line curves 524 to 527) showing how the beam current can be varied in the manner described above. Each curve 524 to 527 corresponds to a different landing energy (524 = 2.5keV, 525 = 2.0keV, 526 = 1.5keV, 527 = 1keV) but the same physical configuration (same beam limiting aperture diameters and hardcoded off-axis corrections) and the same image plane. Each curve 524 to 527 has a 90 degrees rotated parabolic-like form. In curve 527, both the upper and lower branches of the parabola are shown. In curves 524 to 526, only the upper branch is shown for clarity (i.e. the branch where beam current increases with increasing resolution), although both branches exist. The device may be configured to implement each selectable beam current by selecting a corresponding demagnification of the control lens array 250. Each demagnification corresponds to a different beam current. In the example of **FIG. 11,** the different points on each of the curves 524 to 527 correspond to different demagnifications. The demagnification may be adjusted for each curve 524 to 527 to optimize resolution. Alternatively, the demagnification may be adjusted to allow resolution to deteriorate while achieving a larger beam current. As described above, in a case where the control lens array 250 comprises at least three control electrodes, each demagnification (and therefore beam current) may be selected by applying a corresponding potential to the middle control electrode of the three control electrodes.

As mentioned in the introductory part of the description, hardcoded corrections in charged-particle-optical devices may not be optimal in all situations. For example, variations in properties such as field curvature and astigmatism may occur during use of the charged particle-optical device that cause hardcoded corrections to become sub-optimal. In some configurations, for example, changing the landing energy may cause a change in field curvature. This is because changes in landing energy may need to be accompanied by changes in the electric fields between plates of the objective lens array 241 if the image plane is to be kept in the same place. Changes in electric fields may cause changes in field-induced mechanical distortions, such as of the plates, for example as bow of plate electrodes, which affect field curvature. Embodiments described below aim to increase the range of situations (e.g., the range of operating parameters of a charged particle-optical device) for which hardcoded corrections are effective.

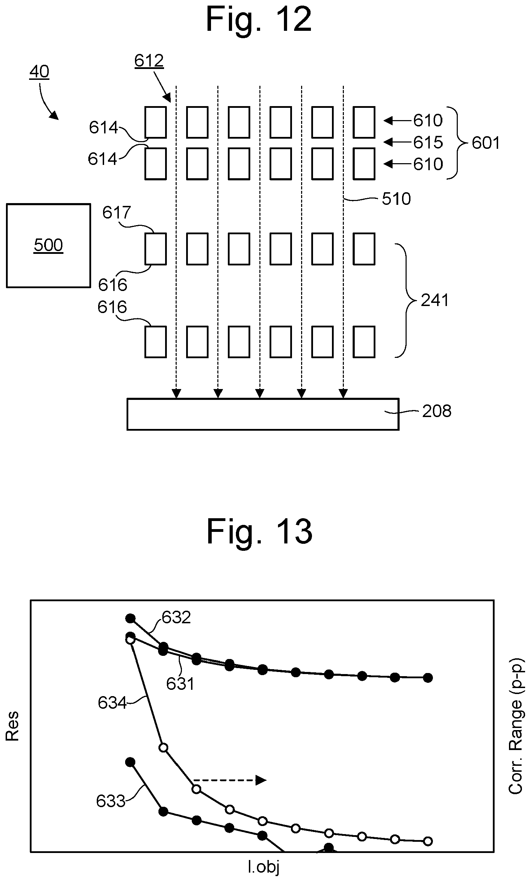

**FIG. 12** schematically depicts a charged particle-optical device 40. Features that are the same as those described above are given the same reference numerals (including for example features described with reference to **FIG. 1-9**). For conciseness, such features are not described in detail with reference to **FIG. 12.**

The charged particle-optical device 40 comprises a lens array configured to focus a plurality of charged particle beams in a beam grid towards a sample position. In **FIG. 12** a sample 208 is positioned at the sample position. The terms multi-beam and beam grid are used interchangeably. The beam grid may thus take any of the forms described herein with reference to a multi-beam.

The lens array may comprise or consist of an objective lens array 241. The objective lens array 241 may take any of the forms described herein with reference to an objective lens array 241 or even an objective lens assembly described herein.

The device 40 further comprises a corrector 601. The corrector 601 may be provided outside of the lens array, for example outside of the objective lens array 241, such up beam of the objective lens array 241. It should be noted that the reference to a corrector is intended to refer to the corrector operable on the beam grid and an array of correctors or corrector elements (or corrector array). The array of correctors are operable on the different respective beams of the beam grid, The corrector is operable on the beam grid to correct aberrations of the beam grid (i.e., the beams in relation to each other).

The corrector 601 comprises at least two aperture arrays 610. Two aperture arrays 610 are shown in the example of **FIG. 12.** Each aperture array may take the form of an electrode, such as a planar electrode e.g. a plate. The aperture of a respective aperture array may be defined in the electrode (e.g. planar electrode such as a plate). It may be considered that each aperture array 610 comprises a respective plate (for example in such a plate or electrode may be defined the apertures of such an aperture array). The plates may be conductive or have a conductive coating. The plates may therefore define equipotential surfaces. The plates may be referred to as electrodes. Each aperture array defines a plurality of apertures. An example aperture 612 is labelled in **FIG. 12.** Each plate may be arranged so that perimeters of the apertures in the array are connected together electrically to be at the same electrical potential as each other (e.g., to form part of the same equipotential surface). The plates may be arranged in series along beam paths 510 of the beam grid. Five example beam paths 510 are shown by broken lines in **FIG. 12,** although there may be many more, for example one hundred, one thousand, ten thousand and, in an arrangement, one hundred thousand or more (although such an arrangement may be suited to an arrangement having a plurality of beam grids derived from different sources). Each beam path 510 may intersect a respective aperture 612 in each of the aperture arrays. Apertures in different aperture arrays may therefore be aligned with each other along respective beam paths 510. The objective lens array 241 and, where present, the control lens array 250 may also comprise such aperture arrays, which may be referred to as plates or electrodes. Aperture arrays of the objective lens array 241 and/or control lens array 250 are distinct from the aperture arrays 610 of the corrector 601.

Each aperture array 610 of the corrector 601 defines an array of apertures having an aperture pattern. The aperture arrays 610 of the corrector 601 comprise one or more pairs of facing aperture surfaces 614. The facing aperture surfaces face each other across a gap 615. The gap 615 may be referred to as a corrector pair gap 615. The facing aperture surfaces 614 in each pair are of adjacent aperture arrays 610. **FIG. 12** depicts an example with one pair of facing aperture surfaces 614.

Each pair of facing aperture arrays 614 corresponds to a species of correction for a respective aberration of the beam grid. The form of the apertures (such as shape, position and size of the apertures) and the form of the relative positions of the apertures in the array defined in the plate of the aperture array may be referred as an aperture pattern. The aperture pattern defined in at least one of the facing aperture surfaces 614 of the pair is configured to apply the respective species of correction to the beam grid. The aperture pattern defines characteristics of the apertures in the aperture and of the aperture array. The aperture pattern in one or both of the facing aperture surfaces 614 thus defines the species of correction to be applied. The aperture pattern may be referred to as a fingerprint corresponding to the species of correction.

The device 40 may comprise a voltage supply 500 (which may operate as a potential source and may be the same as or different from the potential source mentioned with respect to **FIG. 3 to 5**). Alternatively, voltage supply 500 may be a separate element, in which the device 40 may be referred to as a charged particle-optical module. The device 40 may comprise a controller configured to control potentials applied by the voltage supply 500. The controller may be part of the voltage supply 500. The voltage supply 500 is configured to apply a potential difference between the facing aperture surfaces 614 of the pair to cause the species of correction corresponding to the pair to be applied to the beams of the beam grid. The potential difference may be applied between the facing aperture surfaces across the corrector pair gap 615. In some arrangements, the device 40 comprises a plurality of the pairs of facing aperture surfaces 614. Each pair may be configured to apply a different respective species of correction to the beam grid. Each different species of correction may be configured to correct for a different respective aberration of the beam grid. The voltage supply 500 may be configured to apply a potential difference between the facing aperture surfaces 614 of each pair. The applied potential differences will cause respective species of correction corresponding to the pairs of facing aperture surfaces to be applied to the beams of the beam grid. In some arrangements, each potential difference may be controlled independently, thereby allowing magnitudes of the applied species of correction to be controlled independently of each other. The voltage supply may be configured to vary the magnitude of the species of correction over a respective correcting range. A lower limit of the correcting range may be substantially zero. A correction applied by each of the pairs of facing aperture surfaces 614 may effectively thus be turned off when not required.

In an arrangement, each of the aperture arrays 610 comprises an electrical connection to the voltage supply 500. In an arrangement, each of one or more (optionally all) of the aperture arrays 610 of the corrector 601 is configured to be controllable via a single electrical connection to the aperture array 610. The single electrical connection allows a potential to be applied to a facing aperture surface 614 defined by the aperture array 610 for applying one of the species of correction. For example, at least the perimeters of apertures in the aperture array (and preferably the surfaces around the apertures) may be connected together electrically (for example as a continuous surface in which the apertures are defined) so as to be at the same electrical potential as each other, thereby defining an equipotential, and the single electrical connection may be connected to the same equipotential (which may be different to a potential, such as ground, applied to a different component in order to define a desired potential difference).

In some arrangements, the corrector 601 is configured such that the applied potential difference for the or each pair of facing aperture surfaces 614 is selectable for a magnitude of the respective applied species of correction. The selection of a magnitude of respective applied species of correction is substantially independent of focusing of the beam grid at a sample position. For example, in some arrangements, the or each pair of facing aperture surfaces 614 may be configured to have a focusing strength when applying the respective species of correction that is substantially weaker than any of lenses of the lens array (e.g., objective lens array 241).

In some arrangements, the or each pair of facing apertures surfaces 614 is configured such that a lensing effect of the facing aperture surfaces 614 substantially cancels apart from applying the respective species of correction to the beams of the beam grid. This may be achieved, for example, by arranging for the facing aperture surfaces 614 to be relatively close together in comparison with aperture arrays of the lens array. For example, the facing aperture surfaces 614 may be separated by a distance less than about 100 microns, optionally less than about 75 microns, optionally less than about 50 microns.

For a given electric field strength between facing aperture surfaces, reducing the distance between the facing aperture surfaces reduces a beam energy difference of beams passing through the lenses formed by the facing aperture surfaces. Apertures in one of the facing aperture surfaces will act as positive lenses and apertures in the other of the facing aperture surfaces will act as negative lenses. If the beam energies are similar the lensing effects will cancel to a large extent. This can be seen from the following expressions for the focal length of the positive lens, $f_{pos}$, and the focal length of the negative lens, $f_{neg}$, corresponding to the facing apertures:

$$f_{pos} = 4 \cdot \frac{U}{E} + 0.6d$$

$$f_{neg} = \frac{-4 \cdot (U + \Delta U)}{E} + 0.6d$$

where $U$ is the beam energy, $\Delta U$ is the difference in beam energy between the facing aperture surfaces, $E$ is the electric field strength between the facing aperture surfaces, and $d$ is the diameter of the apertures. It can be seen that the first term in each expression will be similar in size but opposite in sign when $\Delta U$ is small. This represents the cancelling effect mentioned above. The second term in each expression will add together (i.e., not cancel) leading to an overall focusing effect that depends on the diameter of the facing apertures. Providing a variation in the diameters of the apertures in the aperture facing surfaces may thus be used to define a species of correction. The magnitude of the correction can be tuned by selecting the potential difference between the facing aperture surfaces. The magnitude of the correction may scale with the lens strength of lenses defined by the apertures to the power of two. Thus, the magnitude grows quickly as a function of lens strength. Increasing the electric field strength and/or lowering the beam energy will increase the lens strength. Other species of correction can be defined analogously by varying other features of the aperture pattern, including for example varying shapes and/or positions of the apertures.

An overall effect on the beam grid from each pair of facing aperture surfaces may comprise a common focusing effect and a correcting focusing effect. The common focusing effect is an effect that is common to (e.g., the same for) all beams of the beam grid. For example, the common focusing effect may comprise a focusing effect that is the same for all beams of the beam grid. The common focusing effect may for example have the same magnitude for all of the beams. The correcting focusing effect is an effect that is different for at least a portion of the beams of the beam grid. The correcting focusing effect may be defined for example by a variation in the sizes of the apertures in the aperture pattern. The common focusing effect may have a larger magnitude than the correcting focusing effect despite the cancelling effect mentioned above. This will not prevent the correcting focusing effect because the common focusing effect is the same for all of the beams. However, it may be desirable to reduce or remove the common focusing effect.

In some arrangements, the voltage supply 500 is configured to apply a compensating potential difference between compensating aperture facing surfaces outside of the corrector 601 to at least partially compensate the common focusing effect. The common focusing effect is applied by the corrector 601 while the corrector 601 applies one or more of the species of correction. Effects of the corrector 601 corresponding to the applied species of correction are thus left behind after the common focusing effect has been compensated, even if the compensation is complete compensation. The common focusing effect is compensated while allowing the desired species of correction to be applied. The common focusing effect may result from applying a potential difference between each of one or more pairs of facing aperture surfaces. A size of the common focusing effect arising from each pair of facing aperture surfaces that are used to apply a species of correction may vary as a function of the potential difference applied across the pair. In some arrangements, the voltage supply 500 may therefore vary an applied compensating potential difference as a function of the magnitude or magnitudes of respective species of correction applied by the corrector 601.

The compensating aperture facing surfaces outside of the corrector 601 may be provided specifically for this purpose or may form part of a charged particle-optical element intended to perform one or more other roles in addition. For example, the compensating aperture facing surfaces may form part of the objective lens array 241 or a control lens array 250,.

In some arrangements the lens array (e.g., objective lens array 241) comprises a plurality of lens aperture array surfaces 616 arranged in series along beam paths 510 of the charged particle beams of the beam grid. An up beam surface 617 of the aperture array that faces a surface of the corrector 601 may serve as a compensating aperture facing surface.

In an arrangement, the or each species of correction is configured to correct a beam property of the beams on a macroscopic scale across the beam grid. The beam property may for example include one or more of beam focus, beam astigmatism, and beam positioning. Each species of correction may be used to correct for an aberration originating, for example from another electron-optical element in the electron-optical device, for example from a macroscopic effect, such as from a macroscopic collimator or an electrostatic pressure induced bow of a charged particle-optical element. In the case where the beam property comprises beam focus, the species of correction may be used to correct field curvature on a macroscopic scale and/or to control a tilt of a plane of focus of the beam grid, such as a tilt about one or more axes parallel to a plane of the sample (which may be referred to as Rx and Ry for tilts with respect to orthogonal X and Y axes in a Cartesian frame of reference). Controlling the tilt of a plane of focus of the beam grid may be particularly desirable in the context of a multicolumn arrangement such as the charged particle-optical device array 400 discussed above with reference to **FIG. 4** (e.g., in which a plurality of beam grids derived from different respective sources are directed onto the same sample 208). In a single column arrangement (having a single charged particle-optical device) an Rx/Ry error can be corrected by tilting the sample 208 using a stage but this is not normally possible in a multi-column arrangement (e.g., charged particle-optical device array 400) where the Rx/Ry error may be different for different columns (different charged particle-optical devices).

The species of correction applied by a pair of facing aperture surfaces 614 can be defined by suitable configuration of the aperture pattern of one or both of the facing aperture surfaces 614. For at least one of the pairs of facing aperture surfaces 614, the aperture pattern in at least one of the facing aperture surfaces 614 may have a perturbed form. Desirably both of the aperture patterns have a perturbed form. The perturbed form may be the same for each of the two facing aperture surfaces 614 of the pair. In this case, the perturbed form may be referred to as a common perturbed form. The perturbed aperture pattern may comprise an aperture pattern that is different from a nominal aperture pattern. In an aperture array having a nominal aperture pattern all apertures may for example have the same shape (e.g. circular), size and/or a position within the aperture array on a nominal grid (e.g., a regular grid). An aperture array having the perturbed aperture pattern may be different in at least one of a dimension, position, pitch, and/or shape (e.g. corresponding to an order of astigmatism) of one or more of the apertures in the aperture array of the aperture pattern. In some arrangements, the perturbed form and/or common perturbed form of aperture array desirably comprise one or more of the following: a range of aperture shapes, a range of aperture sizes and/or a range of aperture position deviations relative to nominal aperture grid positions. For example, in a case of an astigmatism correction, an elliptical shape is needed. For the correction of the two facing aperture surfaces 614 to add up (i.e., of the positive and the negative lens), the shapes of corresponding apertures in the two aperture facing surfaces 614 should be orthogonal with respect to each other. The directions of the respective long axes should therefore be 90 degrees rotated (180/2)). In case of a triangle shape, the corresponding apertures should be 180/3=60 degrees rotated. In case of a square shape, the corresponding apertures should be 180/4=45 degrees rotated.

In an arrangement, the aperture pattern of an aperture array may take any of the forms described above with reference to **FIG. 6-8.** In an embodiment, the nominal aperture pattern may comprise a regular array of circular apertures having the same size. The perturbed form may comprise differences in aperture areas across the aperture pattern relative to the nominal aperture pattern, as described with reference to **FIG. 6.** Providing a range of aperture areas, for example over the aperture pattern, may allow a species of correction to be applied that is suitable for correcting for a variation in field curvature across the beam grid and/or for controlling a tilt of a plane of focus of the beam grid (e.g., to correct Rx or Ry). Alternatively or additionally, the perturbed form may comprise differences in shape such ellipticities for a second order astigmatism, across the aperture pattern relative to the nominal aperture pattern, as described with reference to **FIG. 7.** Providing a range of ellipticities may allow a species of correction to be applied that is suitable for correcting a variation in astigmatism, such as second order astigmatism, across the beam grid. Alternatively or additionally, the perturbed form may comprise displacements from nominal grid positions in the nominal aperture pattern, as described with reference to **FIG. 8.** Providing a range of displacements from nominal grid positions may allow a species of correction to be applied that is suitable for correcting a distortion of the beam grid such as may be caused by telecentricity error (or (electron-optical) distortion).

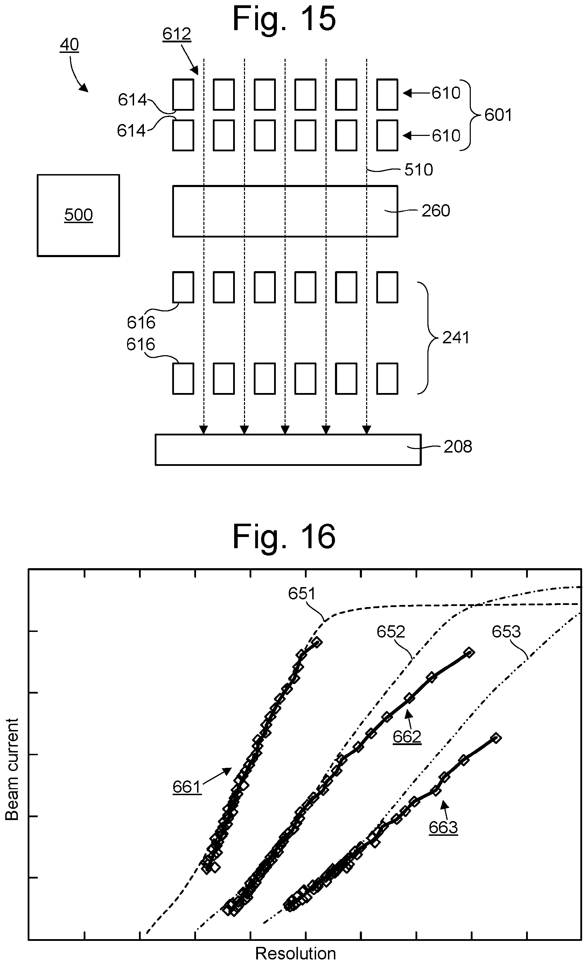

**FIG. 13-14** depict the results of simulations showing the performance of a charged particle-optical device 40 comprising a corrector 601 according to an embodiment of the disclosure. The simulations used an analytical model Monte Carlo simulation. In the simulation, it was assumed that the beam energy entering the corrector 601 can be changed, for example by a control lens array 250 provided upbeam of the corrector 601. The object imaged on the sample 208 in the simulation was a Gaussian spot located at a selected distance up beam of the objective lens array 241 in an arrangement as depicted in **FIG. 15.**

In a first step of the simulation, numerical evaluation of performance was performed with the corrector 601 turned off. A landing energy was set such that an electric field strength in the objective lens 241 equals a selected value. A position of a nominal image plane was calculated. The resolution was evaluated at these settings over a defocus range of +/- 250nm.

In a second step of the simulation, numerical evaluation of performance was performed with the corrector 601 turned on maximally. A beam energy at the upbeam most electrode of the objective lens array 241 was tuned such that the focus is set at the same position as with the corrector 601 off with an aperture diameter in the corrector 601 equal to a selected size. The diameter of the aperture in the corrector 601 was then varied over a range in the simulation and the resulting focus correction range on the sample 208 was calculated.

**FIG. 13** depicts results from the simulation for a positive difference in beam energy between the facing aperture surfaces of the corrector, i.e. $\Delta U$, of a selected magnitude across the corrector 601. The horizontal axis represents a thickness of the objective lens array 241 (l.obj), i.e., the separation between the two aperture arrays of the objective lens array 241. Decreasing the thickness of the objective lens array 241 has the effect of decreasing beam energy on the object side of the objective lens array 241 in the simulation because the electric field strength in the objective lens array 241 is kept constant and the landing energy is not changed. Decreasing the beam energy on the object side of the objective lens array 241 increases the strength of the corrector 601. Thus, as shown in **FIG. 13,** the strength of the corrector 601 increases from right to left along the horizontal axis.

Curves 631-633 with solid circle data points represent resolution (Res) (lefthand vertical axis). Curve 631 represents variation of resolution with corrector strength for the case where the corrector 601 is turned off. The resolution gets worse as the corrector strength increases due to the objective lens array 241 becoming thinner but the effect is not very large. Curve 632 represents variation of resolution with corrector strength for the case where the corrector 601 is turned on. Curve 633 depicts how the root-sum-square difference in resolution between curves 631 and 632 varies as a function of corrector strength.

Curve 634 with open circle data points represents a range of correction (Corr. Range (p-p)) (righthand vertical axis). The horizontal broken line arrow indicates that the righthand vertical axis applies curve 634. Curve 634 shows a sharp upward trend as a function of increasing corrector strength. Thus, while increasing corrector strength can lead to a small decrease in resolution performance, as shown in curves 631-633, there is a noticeable/notable beneficial effect in terms of improved range of correction.

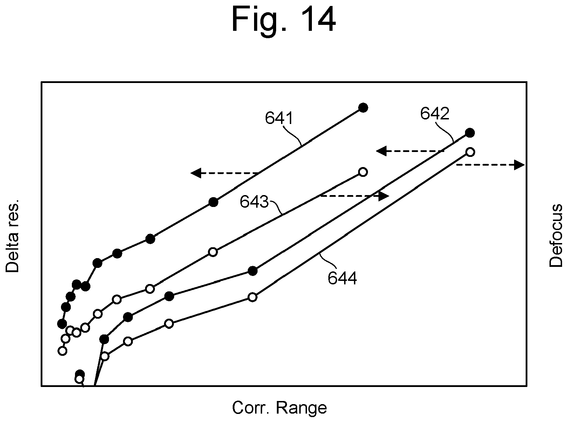

**FIG. 14** depicts a plot of the data of **FIG. 13** in a different way, along with corresponding data from a corresponding simulation for the reversed polarity case (i.e., where a negative difference in beam energy between the facing aperture surfaces of the corrector, i.e. $\Delta U$, is applied across the corrector 601. The correction range (Corr. Range) is represented along the horizontal axis. The additional resolution (Delta res.) is represented along the lefthand vertical axis. Curves 641 and 642 with solid data points are plotted with reference to the lefthand vertical axis and correspond respectively to the simulations of **FIG. 13** and of the reversed polarity case. The horizontal broken line arrows pointing to the left indicate that the lefthand vertical axis applies to curves 641 and 642. The effective defocus that would lead to the same resolution contribution is represented along the righthand vertical axis. Curves 643 and 644 with open data points are plotted with reference to the righthand vertical axis and correspond respectively to the simulations of **FIG. 13** and of the reversed polarity case. The horizontal broken line arrows pointing to the right indicate that the righthand vertical axis applies to curves 643 and 644. From the simulations represented by the curves in **FIG. 14** for the simulated example, it is determined that a correction range of about 10 microns is achieved at a cost of about 100nm defocus. This represents a 100x improvement in defocus.

In an arrangement, a separation between two adjacent lens aperture array surfaces 616 of the lens array is larger, optionally at least 2 times larger, optionally at least 5 times larger, optionally at least 10 times larger, than a distance between the facing aperture surfaces 614 of at least one of the pairs of facing aperture surfaces 614 of the corrector 601. Spacing lens aperture array surfaces 616 further apart from each other than between the pairs of aperture array surfaces 614 within in the corrector 601 enables aperture arrays in the lens array to provide stronger common lensing effects in comparison to the corrector 601. This reflects the different roles of the lens array (and corrector 601. That is the lens array is to focus the beam grid as a whole; whereas the correct is to apply species of correction to the beam grid).

Alternatively or additionally, a separation between the two adjacent lens aperture array surfaces 616 of the lens array may be no more than 50 times larger, optionally no more than 25 times larger, optionally no more than 15 times larger, optionally no more than 10 times larger, than the distance between the facing aperture surfaces 614 of the at least one of the pairs of facing aperture surfaces 614 of the corrector 601. For example, the separation between the lens aperture array surfaces may be less than about 3000 microns, optionally less than about 1000 microns, optionally less than about 500 microns. Despite the different roles mentioned above, it may nevertheless be desirable to make at least a portion of the lens array, for example the objective lens array 241, thinner than usual. For example, as described above with reference to **FIG. 13-14,** this may facilitate lowering of the beam energy in the corrector 601, thereby increasing an operational range of the corrector 601 by increasing a strength of the corrector 601.

**FIG. 16** is a graph showing predicted variation of beam current of the beams of the beam grid against beam resolution at the sample 208 for a typical configuration of a charged particle-optical device 40 of the present disclosure. Data points were obtained as discussed above with reference to **FIG. 10** and **11** by simulating the electrostatic field and ray tracing electrons through the field.

Curves 651-653 represent different landing energies and are analogous to curves 521 and 522 in **FIG. 10** and **11** except that curves 651-653 represent three different landing energies rather than two. Curve 651 represents a highest landing energy, curve 652 an intermediate landing energy, and curve 653 a lowest landing energy. Each position on curves 651-653 represents a distinct physical configuration of the charged-particle device that is optimized for the respective combination of beam current and resolution (including, for example, hard coded off-axis compensations). As described above with reference to **FIG. 11,** it is possible to vary beam current without changing the physical structure of aperture arrays. However, as demonstrated by curves 524-527 in **FIG. 11,** in the absence of a corrector 601 resolution performance rapidly deteriorates as beam current is allowed to increase. The rapid deterioration of the resolution arises due to hardcoded corrections becoming less suitable for correcting aberrations as the beam current increases; that is the deterioration of the resolution is due to a limited range of the electron-optical effect of the hardcoded corrections present in the respective lens aperture arrays for example of the objective lens array. The electron-optical range of the electron-optical corrections applied by a certain set of hardcoded corrections becoming less suitable for correcting aberrations as the beam current increases. This is a consequence, for example, of changing electric field strengths in the objective lens array leading to different amounts of bow, etc. Embodiments of the present disclosure that comprise a corrector 601 allow for improved performance by providing freedom for correcting for aberrations without changing hardcoded corrections for example within the objective lens array. For example, as the beam current increases and makes hardcoded corrections in the objective lens array 241 less effective, the corrector 601 may be used to compensate for the reduced effectiveness of the hardcoded corrections in the objective lens array 241. Example predicted results from apply a corrector 601 in this manner are depicted in **FIG.16** by the three sets of data points 661-663 (represented by squares and connected by thick lines) shown in **FIG. 16** and corresponding respectively to using the corrector 601 to optimize resolution while beam current is varied for each of the three example landing energies corresponding to curves 651-653. Each of the sets of data points 661-663 is seen to follow a respective one of the curves 651-653 closely even though all hardcoded corrections remain the same for all points within each set of data points 661-663.

In some arrangements, based for example on the performance demonstrated by the simulations discussed above with reference to **FIG. 16,** a charged particle-optical device 40 may be configured such that control of a potential difference applied between the or each pair of facing aperture surfaces to apply respective species of correction enables operation of the lens array (e.g., objective lens array 241) to allow adjustment of beam current and/or landing energy of the beams of the beam grid at the sample. Such adjustment is allowed while the applied species of correction compensate for macro aberrations contributed by the adjustment of beam current and/or landing energy. (Note macro-aberrations are aberrations over the beam grid). For example, the beam current may be increased by changing a magnification of the charged particle-optical device (e.g., to move upwards along one of the sets of data points 661-663) while the applied species of correction compensates for macro aberrations caused by the change in magnification (e.g., to prevent the resolution performance deteriorating to a large extent as seen in the curves 524-527 in **FIG. 11**). Similar considerations apply to changing the landing energy, which may need to be accompanied by changes in electric fields between aperture arrays of the objective lens array 241 if the image plane is to be kept in the same place). Changing the landing energy may thus involving changing a potential applied to the lens array (e.g., objective lens array 241). A magnitude of an applied species of correction applied by the corrector 601 may compensate for macro aberrations arising from the change in potential applied to the lens array. In the absence of the corrector 601 it would be difficult to maintain optimally low levels of field curvature and astigmatism correction, particularly in arrangements where electrostatic distortions such as bow may become relatively large. If the beam current is kept constant, the optimal resolution that can be achieved at each landing energy is different. This means that adjusting the landing energy results in an adjustment of the resolution. Thus, the charged particle-optical device 40 is configured to allow adjustment of landing energy so as to adjust resolution. By controlling the potential difference applied to the corrector 601, it is possible to adjust the landing energy so as to adjust resolution independent of adjustment of magnification (e.g., without changing the beam current, which is set by the magnification).

In some arrangements, at least one of the aperture arrays 610 of the corrector 601 is adjacent to another charged particle-optical element different from the corrector 601. In an arrangement, as exemplified in and described with respect to **FIG. 12** (for example earlier herein), the other charged particle-optical element may be the lens array. The lens array may comprise or consist of an objective lens array 241. In other arrangements, as exemplified in **FIG. 15** and **17-20,** the other charged particle-optical element is a deflector adjacent to the lens array. The deflector may comprise or consist of a deflector array 260. The deflector may be positioned upbeam of the lens array, for example such that the objective lens array 241 is between the deflector and the sample 208.

In some arrangements, as exemplified in **FIG. 12, 15** and **17-20,** at least one pair of the facing aperture surfaces 614, for example of a corrector (or an array of corrector elements), is configured to be upbeam of the objective lens array 241. In the examples shown, all of the pairs of facing aperture surfaces 614 are upbeam of the objective lens array 241.

**FIG. 15** depicts a variation on the arrangement of **FIG. 12** in which the charged particle-optical device 40 further comprises deflector array 260 adjacent to the objective lens array 241.

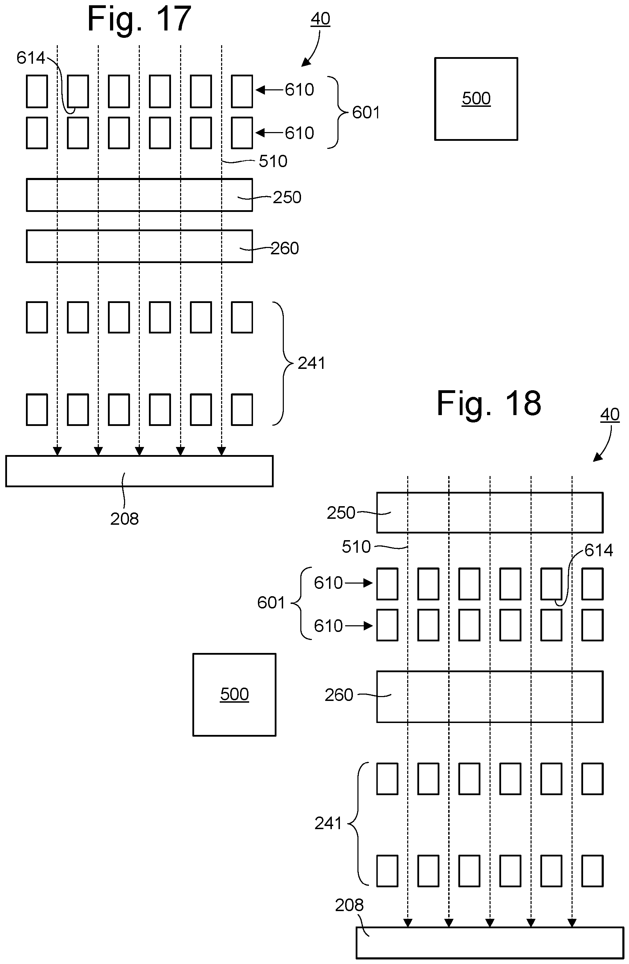

**FIG. 17** depicts a variation on the arrangement of **FIG. 15** in which the device 40 comprises a control lens array 250. The example includes a deflector array 260 but this is not essential. The control lens array 250 may take any of the forms described above, for example with reference to **FIG. 3-5,** for example it may be considered to be part of the objective lens array or it may be separate from the objective lens array. The apertures of the control lens array may hardcoded corrections such as for distortion.. In an arrangement of the example of **FIG. 17,** the control lens array 250 is located downbeam of (e.g., closer to the sample 208 than) the corrector 601. The control lens array 250 in this example is thus at an intermediate position between the corrector 601 and the objective lens array 241. In the example shown, the control lens array 250 is located upbeam of (e.g., further from the sample 208 than) the deflector array 260. In such arrangement the corrector may be considered to be part of the control lens array. The plates of the corrector may be considered to be additional to the plates of the control lens array.

**FIG. 18** depicts a variation on the arrangement of **FIG. 17** in which the control lens array 250 is located on the opposite side of the corrector 601 (e.g., further from the sample 208 than the corrector 601). In this arrangement, the control lens array is considered to be separate from the objective lens array, unless the corrector is also considered to be part of the objective lens array in that the control lens array and the plates of the corrector are additional plates of the objective lens array. The corrector 601 in this example is thus at an intermediate position between the control lens array 250 and the objective lens array 241. In such arrangement the corrector may be considered to be part of the control lens array. The plates of the corrector may be considered to be additional to the plates of the control lens array.

In other arrangements (not shown), the corrector 601 may be integrated within the control lens array 250. For example, one of the aperture arrays of the control electrode array 250, such as a middle aperture array 250, could be split into two aperture arrays and the corrector 601 could be located in between those two aperture arrays. In this arrangement, the plates of the corrector 601 are not merely considered additional plates of the control lens array, but plates of the control lens array and the corrector may be interleaved.

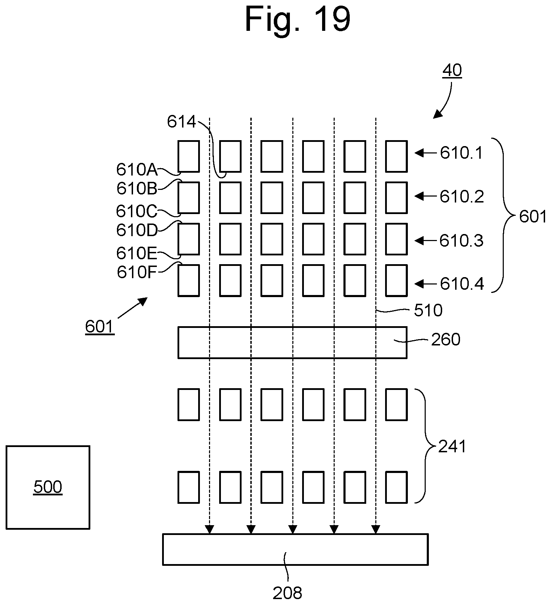

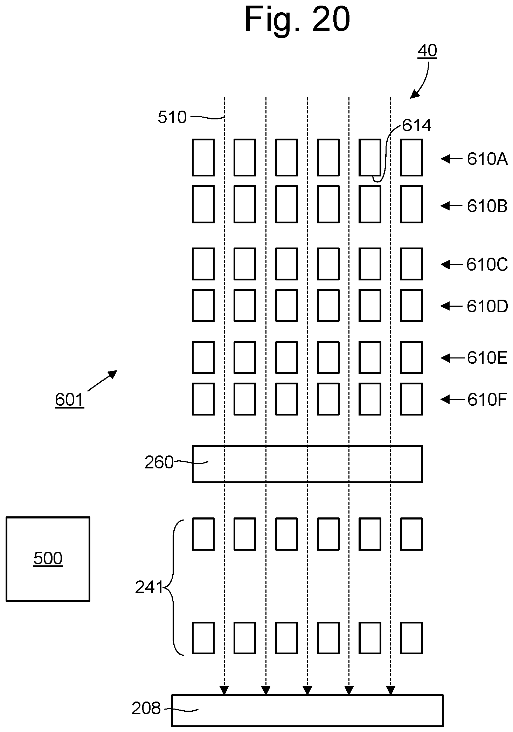

**FIG. 19** and **20** depict variations on the arrangement of **FIG. 15** in which the corrector 601 comprises a plurality of the pairs of aperture facing surfaces 614. In an embodiment, each pair may be configured to be controllable separately from the other pairs (e.g., by setting a potential difference across the pair independently of the potential difference across the other pairs). Each pair may thus provide a separate "knob" that may be adjustable by a user of the charged particle-optical device. Each knob may allow the user to separately define the magnitude of a species of correction corresponding to each pair. In each example, the corrector 601 comprises three pairs of aperture facing surfaces 614 configured to apply different respect species of correction to the beams of the beam grid. In different terminology a pair of aperture facing surfaces may be considered as a corrector. The aperture pattern of the apertures defined in different sides of a plate shared by adjacent correctors may be different. For that reason at least for the arrangement shown and described with reference to **FIG 20,** the plate may have different aperture arrays defined in opposing major sides of a plate. For manufacturing reasons the aperture arrays on either side of a plates is the same for example with the same (e.g., positions of apertures in the) aperture array pattern.

In the example of **FIG. 19,** the three pairs of aperture facing surfaces 614 are defined in four plates in which are defined aperture arrays. The different plates are labelled 610.1, 610.2, 610.3, and 610.4. The three different pairs of facing surfaces may be defined by adjoining facing surfaces of the plates 610.1 to 610.4. A first pair of facing surfaces for applying a first species of correction is defined by facing aperture surfaces between plates 610.1 and 610.2, providing aperture arrays in surface 610A of 610.1 and 610B of 610.2. A second pair of facing surfaces for applying a second species of correction is defined by facing aperture surfaces between plates 610.2 and 610.3, providing aperture arrays in surface 610C of 610.2 and 610D of 610.3. A third pair of facing surfaces for applying a third species of correction is defined by facing aperture surfaces between plates 610.3 and 610.4, providing aperture arrays in surface 610E of 610.3 and surface 610F of 610.4.

**FIG. 19** is an example of an arrangement in which at least two adjacent pairs of facing aperture surfaces or two sequential correctors along the beam path have a facing aperture surface defined by a common plate 610.2, 610.3 in which the aperture array is defined. The common plate 610.2, 610.3 providing an aperture array is thus shared between the two correctors (or the two pairs of facing aperture surfaces 610A & 610B, 610C & 610D). In the particular example of **FIG. 19,** the first corrector (or pair of facing aperture surfaces 610A & 610B) and second corrector (or second pair of facing aperture surfaces 610C & 610D ) are sequential along the path of the beam grid. The two correctors (or pairs of aperture facing surfaces) each have one facing aperture surface 610B, 610C defined by the same plate 610.2, which may be referred to as a second plate (where for example the first plate is plate 610.1). These two aperture surfaces 610B, 610C are opposing major surfaces of the aperture array 610.2 (or are on opposite sides of the second plate 610.2 that provides the respective aperture arrays). Apertures on opposite sides of the second plate 610.2 (e.g,. at opposite ends of corresponding channels through the second plate 610.2) may have different shapes relative to each other in order to apply different corrections. Apertures of different shapes on opposite sides of a channel in a plate may be fabricated for example by performing a lithography and etching processing from each side of the plate separately. Performing lithography and etching from each side of the plate separately allows aperture patterns in the aperture surfaces on opposite sides of the plate to be slightly different relative to each other. The second plate 610.2 is thus a common plate in respect of the first corrector (or first pair of facing aperture surfaces 610A, 610B) and second corrector (or second pair of facing aperture surface 610C, 610D). This means that in setting the potential applied to the first corrector and the second corrector, the potential applied to the common plate 610.2 (i.e., the second plate) should be accounted for in applying the potential settings to the first corrector and second corrector, i.e. the pairs of facing surfaces 610A, 610B, 610C, 610D of the respective correctors, that is the potential applied to a facing surface 610B, 610C of each pair is the same. The second corrector (second pair of facing aperture surfaces 610C, 610D) and third corrector (pair of facing aperture surfaces 610D, 610E) are also adjacent. The second corrector and the third corrector each have one facing aperture surface 610D, 610E defined by the same plate 610.3 (or common plate) being the third plate. The aperture arrays of facing aperture surfaces 610D, 610E are on opposite sides of the third plate 610.3. The third plate 610.3. is thus another example of a common plate providing aperture arrays to different correctors (or two pairs of facing aperture surfaces). The third plate is a common plate in respect of the second and third pairs of facing aperture surfaces. Arrangements comprising such common or shared aperture arrays may enable improvements in compactness of a corrector design featuring a corrector with multiple pairs of facing aperture surfaces, or of a corrector design having multiple correctors for example in being in arranged serially.

In the example of **FIG. 20,** the three pairs of aperture facing surfaces 614 are defined by six plates labelled 610A-F each having a respective aperture array. A first pair of aperture facing surfaces 614 is defined by the facing aperture surfaces of the plates 610A and 610B. A second pair of aperture facing surfaces 614 is defined by the facing aperture of the plates 610C and 610D. A third pair of aperture facing surfaces 614 is defined by facing aperture surfaces of the plates 610E and 610F. In an arrangement in which each pair of aperture facing surfaces defines a different corrector, the arrangement shown in and depicted with reference to **FIG. 20** shows three separate and different correctors arranged sequentially along the beam path.

**FIG. 20** is an example of an arrangement in which at least one of the correctors (pairs of facing aperture surfaces 614) are of adjoining plates specific to the respective corrector (pair of facing aperture surfaces 614). Thus an aperture array defined in each of the two surfaces of the corrector (i.e. the two facing surfaces of the corrector) may apply to both sides of the respective plate provided by the different surfaces. This is different from a common plate of the arrangement shown in and described with reference to **FIG. 19** in which the aperture arrays on opposite major surfaces may be different at least in respect to their aperture patterns. In the example of **FIG. 20,** all of the aperture arrays are specific to a respective pair of facing aperture surfaces 614. None of the plates is a common plate or has different aperture arrays on opposing surfaces of the plate. A corrector arrangement comprising a corrector of a pair of facing aperture surfaces defined plates specific to the corrector (for example without providing a facing surface to a different, adjacent corrector) may facilitate independent operation of the corrector, for example with respect to different, adjoining correctors, for example of different, adjoining pairs of facing aperture surfaces. The corrector may apply a species of correction without considering the impact on the pair of facing surfaces of an adjoining corrector (for example in a common plate having a potential influencing the operation of both of the adjoining correctors). This approach may facilitate independent control of potential differences across different pairs of facing aperture surfaces.

The corrector arrangements shown in and described with reference to **FIG. 19 and 20** may be considered to be different types of corrector. The corrector arrangement of **FIG 19** has three correctors applying different respective fingerprints of correction (or applying different respective species of correction to the beams of the beam grid) each of which can be controlled separately, but dependently because control of a potential to a common plate controls the two correctors of which the corrector forms part. The corrector arrangement of **FIG. 20** has three correctors applying different respective fingerprints of correction (or applying different respect species of correction to the beams of the beam grid) each of which can be controlled separately, so that the plates of adjacent correctors may have different potentials. The surfaces of the plates defining different correctors such as between plates 610B and 610C or 610D and 610E may have common potentials; that is the facing surfaces of adjoining correctors may provide field free regions between the adjoining correctors. A corrector arrangement may have both types of corrector: a separately controllable corrector in which the corrector comprises its own plates which can be set to a different potential of an adjacent corrector; and at least two separately but dependently controllable correctors in that one of the correctors has a common plate and common potential for two adjacent correctors.

Any of the charged particle-optical devices 40 disclosed herein may be implemented as part of a charged particle-optical assessment apparatus. The assessment apparatus may comprise a stage 209 for supporting the sample 208. The stage 209 may take any of the forms described above, for example with reference to **FIG. 2.**
Any of the charged particle-optical devices 40 disclosed herein may be implemented as part of a multi-source charged particle-optical device array. The array of devices, or a device array 400 may comprise a plurality of the charged particle-optical devices 40. The assessment apparatus may comprise such a multi-source charged particle-optical device array. Each source may be assigned to a respective charged particle-optical device. Such an arrangement may be referred to as a multi-device charged particle optical array. The different devices of the arrangement may be arranged in an array for example corresponding to the arrange of sources. The multi-source charged particle-optical device array may be configured in any of the ways described above with reference to **FIG. 4,** for example as a multi-device charged particle optical array, for example as schematically depicted. Each device 40 may be configured to focus a plurality of charged particle beams from a beam of charged particles emitted by a different respective source of a plurality of sources. The devices 40 of the array may be arranged to focus respective pluralities of charged particle beams onto different regions of the same sample 208, for example direct respective beam grids towards respective regions of the sample surface.

Embodiments of the disclosure may be provided as methods, including any of the methods of using the apparatuses described above. The methods include using a lens array to focus a plurality of charged particle beams in a beam grid towards a sample. A potential difference is applied between a pair of facing aperture surfaces of a corrector 601 to apply a species of correction to the beam grid. The species of correction is defined by an aperture pattern. The magnitude of the applied species of correction is selectable independently of focusing of the beam grid on the sample. The method may comprise varying a beam current of the beams of the beam grid at the sample by changing a magnification, and compensating for macro aberrations caused by the change in magnification by selecting a magnitude of the applied species of correction. Alternatively or additionally, the method may comprise varying a landing energy of the beams of the beam grid at the sample by controlling a potential applied to the lens array, and compensating for macro aberrations caused by the change in potential applied to the lens array by selecting a magnitude of the applied species of correction.

Embodiments of the disclosure described above involve potential differences being applied between corrector electrodes (e.g., which may be referred to as aperture arrays and/or as plates of a corrector 601) and between lens electrodes (e.g., lens electrodes of the control lens array 250 and/or objective lens array 241). The potential differences between these elements may typically relate to (e.g., influence) any of the following characteristics: focus, magnification (noting that beam current is a result of magnification), landing energy, field curvature correction fingerprint (when a corrector configured to correct this is present), astigmatism fingerprint (when a corrector configured to correct this is present), and/or any other fingerprint for which a corresponding corrector is provided). There is, however, not normally a one-to-one correspondence between the listed characteristics and the potential differences that can be used to influence (or control or correct) the characteristics. In other words, the correctors and lenses provide a number of degrees of freedom, and sufficient degrees of freedom to influence all the characteristics (including correcting for all fingerprints for which there is a corresponding corrector), but they are not independent.

For example, a charged particle-optical device may be provided that has a control lens array 250, an objective lens array 241, and a corrector 601 configured to correct a field curvature fingerprint. In this case, it is possible to set the following characteristics (effects): Focus; Magnification (beam current is a result of magnification); Landing energy; Field curvature (FC) correction fingerprint. Thus, four characteristics can be set in total. We have the following knobs:

a control lens array top electrode potential, which is fixed at the beam energy of the electron source and so cannot be freely adjusted;

(1) a control lens array mid electrode potential, which typically can be adjusted;
(2) a control lens array bottom electrode potential, which typically can be adjusted;
(3) an FC corrector lower electrode potential (noting that a top electrode of the corrector in this example is constrained to be at the same potential as the control lens array bottom electrode and so is not separately controllable).
(4) Objective lens array bottom electrode potential (noting that an objective lens array top electrode potential is constrained to be at the same potential as the control lens array bottom electrode and the corrector lower electrode and so is not separately controllable).

With these four degrees of freedom it is possible to set the four characteristics (effects) mentioned above (focus, magnification, landing energy, field curvature fingerprint). However the degrees of freedom are not independent.

The positioning of the corrector 601 in the examples described above is purely exemplary and non-limiting. The corrector 601 may be positioned anywhere where the functionality of the corrector 601 is useful. The corrector 601 can be placed before or after a collimator. Typically, it is preferably to position the corrector 601 after a collimator. This is because if the corrector 601 is placed before a collimator, alignment of the charged particle-optical device (or column) would be changed when changing the strength of the corrector 601. This change in the alignment would then need to be corrected for, for example by changing a strength of the collimator. Such a need to change the strength of the collimator in response to changes in the strength of the corrector 601 increases complexity in comparison to alternative configurations in which the corrector 601 is positioned after the collimator.

References to upper and lower, up and down, above and below, etc. should be understood as referring to directions parallel to the (typically but not always vertical) up-beam and down-beam directions of the electron beam or multi-beam impinging on the sample 208. Thus, references to up beam and down beam are intended to refer to directions in respect of the beam path independently of any present gravitational field.

The embodiments herein described may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beam paths of the multi-beam. Electrodes may be present above, below or between the pole plates to control and optimize the electromagnetic field of the compound lens array.

Where electrodes or other elements are provided that can be set to different potentials relative to each other it will be understood that such electrodes/elements will be electrically isolated from each other. If the electrodes/elements are mechanically connected to each other, electrically insulating connectors may be provided. For example, where electrodes/elements are provided as a series of conductive plates that each define an aperture array, for example to form an objective lens array, control lens array or corrector, electrically insulating plates may be provided between the conductive plates. The insulating plates may be connected to the conductive plates and thereby act as insulating connectors. The conductive plates may be separated from each other along sub-beam paths by the insulating plates. In an insulating plate there may be defined an aperture around the path of the multi-beam of sub-beams (e.g. around all the sub-beams).

An assessment tool or assessment system according to the disclosure may comprise apparatus which makes a qualitative assessment of a sample (e.g. pass-/fail), one which makes a quantitative measurement (e.g. the size of a feature) of a sample or one which generates an image of map of a sample. For example, the assessment tool could be any of the charged particle-optical device, e.g. as part of charged particle beam apparatus 100, or more specifically the charged particle-optical device 40 (which may be a charged particle-optical column), and/or as part of an optical lens array assembly, when used for assessment. Examples of assessment tools or systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The charged particle beam tool 40 (which may be a charged particle -optical column) may be a component of an assessment tool; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

Functionality provided by the controller or control system or control unit may be computer-implemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. The one or more computer programs may be provided in the form of media, optionally non-transitory media, storing computer readable instructions. When the computer readable instructions are read by the computer, the computer performs the required method steps. The computer may consist of a self-contained unit or a distributed computing system having plural different computers connected to each other via a network.

Reference to a component or system of components or elements being controllable to operate on a charged particle beam in a certain manner includes configuring a controller or control system or control unit to control the component to operate on the charged particle beam in the manner described, as well as optionally using other controllers or devices (e.g. voltage supplies and/or current supplies) to control the component to manipulate the charged particle beam in this manner. For example, a voltage supply may be electrically connected to one or more components to apply potentials to the components, such as in a non-limited list including the controller 50, control lens array 250, the objective lens array 241, the condenser lens 231, correctors, and scan deflector array 260, under the control of the controller or control system or control unit. An actuatable component, such as a stage, may be controllable to actuate and thus move relative to another components such as the beam path using one or more controllers, control systems, or control units to control the actuation of the component.

A computer program may comprise instructions to instruct the controller 50 to perform the following steps. The controller 50 controls the charged particle beam apparatus to project a charged particle beam towards the sample 208. In an embodiment the controller 50 controls at least one charged particle-optical element (e.g., a lens array such as an objective lens array, control lens array, condenser lens or lens array, a corrector, an array of multiple deflectors or scan deflectors 260) to operate on the charged particle beam in the charged particle beam path. Additionally or alternatively, in an embodiment the controller 50 controls at least one charged particle-optical element (e.g. the detector 240) to operate on, such as detect, charged particles emitted from the sample 208 in response to the charged particle beam.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector. References to elements being aligned along a beam path or sub-beam path are understood to mean that the respective elements are positioned along the beam path or sub-beam path. References to optics are understood to mean electron-optics.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided the following clauses.

Clause 1. A charged particle-optical device comprising: a lens array configured to focus a plurality of charged particle beams in a beam grid towards a sample position; a corrector comprising at least two aperture arrays in which are defined corresponding arrays of apertures each having an aperture pattern, the at least two aperture arrays comprising one or more pairs of facing aperture surfaces of adj acent aperture arrays, each pair of facing aperture surfaces corresponding to a species of correction for a respective aberration of the beam grid, the aperture pattern defined in at least one of the facing aperture surfaces of the pair being configured to apply the respective species of correction to the beam grid; and a voltage supply configured to apply a potential difference between the or each pair of facing aperture surfaces to cause the respective species of correction to be applied to the beams of the beam grid, the applied potential difference selectable to define a magnitude of the respective species of correction substantially independently of focusing of the beam grid at a sample position.

Clause 2. The device of clause 1, wherein the or each pair of facing aperture surfaces is configured to have a focusing strength when applying the respective species of correction that is substantially weaker than lenses of the lens array.

Clause 3. The device of clause 1 or 2, wherein the or each pair of facing aperture surfaces is configured such that a lensing effect of the facing aperture surfaces of the pair substantially cancels apart from applying the respective species of correction to the beams of the beam grid.

Clause 4. The device of any preceding clause, wherein the voltage supply is configured to apply a compensating potential difference between compensating aperture facing surfaces of aperture arrays outside of the corrector, the compensating potential difference configured to at least partially compensate a common focusing effect applied by the corrector while the corrector applies one or more of the species of correction, the common focusing effect being a focusing effect common to all beams of the beam grid.

Clause 5. The device of clause 4, wherein the voltage supply is configured to vary the applied compensating potential difference as a function of the magnitude or magnitudes of respective species of correction applied by the corrector.

Clause 6. The device of any preceding clause, wherein, for at least one of the pairs of facing aperture surfaces, the aperture pattern in at least one of the facing aperture surfaces has a perturbed form, desirably both of the aperture patterns have a perturbed form, which is desirably a common perturbed form, desirably a perturbed aperture pattern being an aperture pattern that is different from a nominal aperture pattern, for example different in at least one of a dimension, position, pitch, and/or shape of one or more of the apertures in the aperture pattern, desirably wherein the perturbed form or common perturbed form desirably comprises one or more of the following: a range of aperture shapes, a range of aperture sizes and/or a range of aperture position deviations relative to nominal aperture grid positions.

Clause 7. The device of any preceding clause, wherein the lens array comprises a plurality of lens aperture array surfaces arranged in series along beam paths of the charged particle beams of the beam grid.

Clause 8. The device of clause 7, wherein a separation between two adjacent lens aperture array surfaces of the lens array is larger than a distance between the facing aperture surfaces of at least one of the pairs of facing aperture surfaces of the corrector, desirably at least 2 times larger and/or no more than 50 times larger.

Clause 9. The device of any preceding clause, wherein the corrector comprises a plurality of the pairs of facing aperture surfaces and each pair is configured to apply a different respective species of correction to the beam grid, optionally wherein each pair is configured to be controllable separately from the other pairs, for example to separately define the magnitude of the respective species of correction.

Clause 10. The device of any preceding clause, wherein the or each species of correction is configured to correct a beam property of beams on a macroscopic scale across the beam grid, the beam property desirably including one or more of: beam focus; beam astigmatism, beam positioning.

Clause 11. The device of any preceding clause, wherein each of one or more of the aperture arrays of the corrector is configured to be controllable via a single electrical connection to the aperture array, desirably controllable to apply a potential to a facing aperture surface defined by the aperture array for applying one of the species of correction.

Clause 12. The device of any preceding clause, wherein the voltage supply is configured to vary the magnitude of at least one of the species of correction over a respective correcting range, desirably a limit of the correcting range being substantially zero.

Clause 13. The device of any preceding clause, wherein at least one of the aperture arrays of the corrector is adjacent to another charged particle-optical element different from the corrector, the other charged particle-optical element being the lens array or a deflector, such as a deflector array, that is adjacent to the lens array.

Clause 14. The device of any preceding clause, wherein the lens array comprises or consists of an objective lens array.

Clause 15. The device of clause 14, wherein the corrector is outside of the objective lens array.

Clause 16. The device of clause 15, wherein at least one pair of the facing aperture surfaces of the corrector is configured to be upbeam of the objective lens array.

Clause 17. The device of any preceding clause, wherein the corrector comprises a plurality of the pairs of facing aperture surfaces and desirably comprises more than two aperture arrays.

Clause 18. The device of clause 17, wherein the respective species of correction of the pairs are configured for correcting different respective aberrations of the beam grid.

Clause 19. The device of clause 17 or 18, wherein the voltage supply is configured to control magnitudes of the respective species of correction independently of each other.

Clause 20. The device of any of clauses 17 to 19, wherein at least one of the pairs of facing aperture surfaces are of two of the aperture arrays unique to the respective pair of facing aperture surfaces.

Clause 21. The device of any of clauses 17 to 20, wherein at least two adjacent pairs of facing aperture surfaces have a facing aperture surface defined by a common aperture array, desirably the common aperture array being shared between the two pairs of facing aperture surfaces, desirably the more than two aperture arrays of the corrector comprising the common aperture array.

Clause 22. The device of any preceding clause, wherein the voltage supply is configured to: control the lens array to selectively vary a beam current of the beams of the beam grid at the sample by changing a magnification of the charged particle-optical device; and use the corrector to compensate for macro aberrations caused by the change in magnification by applying one or more of the species of correction to the beams of the beam grid.

Clause 23. The device of any preceding clauses, comprising a controller configured to control potentials applied by the voltage supply.

Clause 24. The device of any preceding clause, wherein the aperture arrays each comprise a plate in which the corresponding arrays of apertures are defined.

Clause 25. The device of any preceding clause, wherein each of the aperture arrays comprises an electrical connection to the voltage supply.

Clause 26. A multi-source charged particle-optical device array comprising: a plurality of the charged particle-optical devices of any preceding clause, wherein: each charged particle-optical device is configured to focus a plurality of charged particle beams from a beam of charged particles emitted by a different respective source of a plurality of sources; and the charged particle-optical devices are arranged to focus respective pluralities of charged particle beams onto different regions of the same sample.

Clause 27. A charged particle-optical assessment apparatus comprising a stage configured to support a sample and a device of any preceding clause configured to focus a plurality of charged particle beams in a beam grid towards the sample.

Clause 28. A method of projecting a plurality of charged particle beams towards a sample, comprising: using a lens array to focus a plurality of charged particle beams in a beam grid towards a sample; applying a potential difference between a pair of facing aperture surfaces of a corrector to apply a species of correction to the beam grid, the species of correction defined by an aperture pattern, wherein: the magnitude of the applied species of correction is selectable independently of focusing of the beam grid on the sample.

Clause 29. The method of clause 28, comprising: varying a beam current of the beams of the beam grid at the sample by changing a magnification; and compensating for macro aberrations caused by the change in magnification by selecting a magnitude of the applied species of correction.

Clause 30. The method of clause 28 or 29, comprising: varying a landing energy of the beams of the beam grid at the sample by controlling a potential applied to the lens array; and compensating for macro aberrations caused by the change in potential applied to the lens array by selecting a magnitude of the applied species of correction.

Clause 31. A charged particle-optical module for a charged particle-optical device, the module comprising: a lens array configured to focus a plurality of charged particle beams in a beam grid towards a sample position; and a corrector comprising at least two aperture arrays in which are defined corresponding arrays of apertures each having an aperture pattern, the at least two aperture arrays comprising one or more pairs of facing aperture surfaces of adjacent aperture arrays, each pair of facing aperture surfaces corresponding to a species of correction for a respective aberration of the beam grid, the aperture pattern defined in at least one of the surfaces of the pair being configured to apply the respective species of correction to the beam grid, wherein: the module is configured such that a potential difference applied between the or each pair of facing aperture surfaces will cause the respective species of correction to be applied to the beams of the beam grid, and the applied potential difference is selectable to define a magnitude of the respective species of correction substantially independently of focusing of the beam grid at a sample position.

Clause 32. A charged particle-optical module for a charged particle-optical device, the module comprising: a lens array configured to focus a plurality of charged particle beams in a beam grid towards a sample position; and a corrector comprising at least two aperture arrays in which are defined corresponding arrays of apertures each having an aperture pattern, the at least two aperture arrays comprising one or more pairs of facing aperture surfaces of adjacent aperture arrays, each pair of facing aperture surfaces corresponding to a species of correction for a respective aberration of the beam grid, the aperture pattern defined in at least one of the surfaces of the pair being configured to apply the respective species of correction to the beam grid, wherein: the module is configured such that control of a potential difference applied between the or each pair of facing aperture surfaces to apply respective species of correction enables operation of the lens array to allow adjustment of beam current and/or landing energy of the beams of the beam grid at the sample while the applied species of correction compensate for macro aberrations contributed by the adjustment of beam current and/or landing energy.

Clause 33. A corrector for applying a correction to a beam grid projected to a sample position, the corrector comprising: at least two aperture arrays along a path of the beam grid so that adjacent aperture arrays have a pair of facing aperture surfaces corresponding to a species of correction for a respective aberration of the beam grid, apertures in one or both of surfaces of the pair of the aperture surfaces having a fingerprint corresponding to the species of correction, wherein the magnitude of the individual species of correction applied to the beam grid is selectable by adjusting a single control potential applied between the facing aperture surfaces substantially independently of focusing the beam grid at a sample position.

Clause 34. The corrector of 33, wherein control of a potential difference applied to the corrector enables operation of the lens array to be controlled by selection of landing energy and beam current so that adjustment of the landing energy so as to adjust resolution is independent of adjustment of magnification, desirably the adjustment of the landing energy comprises adjustment of the beam current of the beam grid.

Clause 35. The corrector of clause 33 or 34, wherein the corrector is configured to have a focusing strength substantially weaker than any lens of a lens array.

Clause 36. The corrector of clause 35, the lens array configured to control focusing of the beam grid at a sample position.

Clause 37. The corrector of any of clauses 34 to 36, wherein the lensing effect of each facing array is configured to substantially cancel and provide a correcting factor to the beams of the beam grid.

Clause 38. The corrector of any of clauses 34 to 37, wherein an individual aperture array has a single electrical connection configured to apply the control potential.

Clause 39. The corrector of any of clauses 34 to 38, further comprising a voltage supply configured to supply potential difference between adjacent plates of the corrector.

Clause 40. The corrector of clause 39, where each plate has a single connection configured for connecting to the voltage supply.

Clause 41. The corrector of any of clauses 35 to 40, wherein the fingerprint is a perturbed form of the aperture array.

Clause 42. The corrector of clause 41, wherein the perturbed form is configured to correct for stigmation and/or focus.

Clause 43. The corrector of clause 41 or 42, wherein the perturbed form is a variation in form (e.g. size and/or shape) of the apertures.

Clause 44. The corrector of any of clauses 41 to 43, wherein the fingerprint, that is applied to at least one of the plates, comprises a variation in form of aperture relative to the position of the aperture in the beam grid.

Clause 45. The corrector of any of clauses 41 to 44, wherein the voltage supply is configured to be varied so as to apply the correcting factor across a correcting range, desirably a limit of the range is substantially zero.

Clause 46. The corrector of any of clauses 35 to 45, wherein the corrector is adjacent the lens array.

Clause 47. The corrector of any of clauses 35 to 46, wherein the lens array is an objective lens array.

Clause 48. The corrector of any of clauses 36 to 47, wherein the corrector is up beam of the lens array.

Clause 49. The corrector of any of clauses 33 to 48, wherein column comprises a plurality of pairs of facing surface, desirably each pair associated with a different fingerprint that during operation is configured to correct a different aberration of the electron beams of the beam grid.

Clause 50. The corrector of any of clauses 33 to 49, wherein the adjacent correctors: comprise: plates specific to a corrector; or have a common plate.

Clause 51. The corrector of any of clauses 33 to 50, wherein the at least two aperture arrays comprises three sequential plates of aperture arrays positioned along a path of the beam grid, wherein the three sequential plates are configured to provide two pairs of facing surfaces having aperture arrays of different fingerprint.

Clause 52. The corrector of any of clauses 33 to 51, wherein a beam energy difference between adjacent aperture surfaces is small desirably so that the lensing function of the facing aperture surfaces cancel.

Clause 53. The corrector of any of clauses 33 to 52, wherein the distance between the adjacent aperture surfaces is small, desirably so that the difference in beam energy between the facing aperture surfaces is small.

Clause 54. An electron-optical module for an electron-optical column for projecting a beam grid towards a sample, the module comprising: a lens array of lenses configured to project a beam grid towards a sample; a corrector for applying a correction to the beam grid, the corrector comprising: at least two aperture arrays along a path of the beam grid so that adjacent aperture arrays have a pair of facing aperture surfaces corresponding to a species of correction for a respective aberration of the beam grid, apertures in one or both of surfaces of the pair of facing aperture surfaces have a fingerprint corresponding to the species of correction, wherein the magnitude of the individual species of correction applied to the beam grid is selectable by adjusting a single control potential applied between the facing aperture surfaces and the corrector applies the species of correction substantially independently of operation of the lens array on the beam grid.

Clause 55. An electron-optical module for an electron-optical column for projecting a beam grid towards a sample, the module comprising: a lens array of lenses configured to project a beam grid towards a sample; a corrector for applying a correction to the beam grid, the corrector comprising: at least two aperture arrays along a path of the beam grid so that adjacent aperture arrays have a pair of facing aperture surfaces corresponding to [a/at least one] species of correction for a respective aberration of the beam grid, apertures in one or both of surfaces of the pair of facing aperture surfaces have a fingerprint corresponding to the species of correction, wherein control of a difference applied to the corrector enables operation of the lens array is configured to controlled by selection of landing energy and beam current so that adjustment of the landing energy for resolution adjustment is independent of adjustment of magnification for adjusting beam current of the beam grid.

Clause 56. The module of clause 54 or 55, wherein control of a potential difference applied to the corrector enables operation of the lens array to be controlled by selection of landing energy and beam current so that adjustment of the landing energy so as to adjust resolution is independent of adjustment of magnification, desirably the adjustment of the landing energy comprises adjustment of the beam current of the beam grid.

Clause 57. The module of any of clauses 54 to 56, wherein the corrector is configured to have a focusing strength substantially weaker than any of the lenses of the lens array.

Clause 58. The module of any of clauses 54 to 57, the lens array configured to control focusing of the beam grid at a sample position.

Clause 59. The module of any of clauses 54 to 58, wherein the lensing effect of each facing array is configured to substantially cancel and provide a correcting factor to the beams of the beam grid.

Clause 60. The module of any of clauses 54 to 59, wherein an individual aperture array has a single electrical connection configured to apply the control potential.

Clause 61. The module of any of clauses 54 to 60, further comprising a voltage supply configured to supply potential difference between adjacent plates of the corrector.

Clause 62. The module of clause 61, where each plate has a single connection configured for connecting to the voltage supply.

Clause 63. The module of any of clauses 54 to 62, wherein the fingerprint is a perturbed form of the aperture array.

Clause 64. The module of clause 63, wherein the perturbed form is configured to correct for stigmation and/or focus.

Clause 65. The module of clause 63 or 64, wherein the perturbed form is a variation in form (e.g. size and/or shape) of the apertures.

Clause 66. The module of any of clauses 54 to 65, wherein the fingerprint, that is applied to at least one of the plates, comprises a variation in form of aperture relative to the position of the aperture in the beam grid.

Clause 67. The module of any of clauses 54 to 66, wherein the voltage supply is configured to be varied so as to apply the correcting factor across a correcting range, desirably a limit of the range is substantially zero.

Clause 68. The module of any of clauses 54 to 67, wherein the corrector is adjacent the lens array.

Clause 69. The module of any of clauses 54 to 68, wherein the lens array is an objective lens array.

Clause 70. The module of any of clauses 54 to 69, wherein the corrector is up beam of the lens array.

Clause 71. The module of any of clauses 54 to 70, wherein column comprises a plurality of pairs of facing surface, desirably each pair associated with a different fingerprint that during operation is configured to correct a different aberration of the electron beams of the beam grid.

Clause 72. The module of any of clauses 54 to 71, wherein the adjacent correctors: comprise: plates specific to a corrector; or have a common plate.

Clause 73. The module of any of clauses 54 to 72, wherein the at least two aperture arrays comprises three sequential plates of aperture arrays positioned along a path of the beam grid, wherein the three sequential plates are configured to provide two pairs of facing surfaces having aperture arrays of different fingerprint.

Clause 74. The module of any of clauses 54 to 73, wherein a beam energy difference between adjacent aperture surfaces is small desirably so that the lensing function of the facing aperture surfaces cancel.

Clause 75. The module of any of clauses 54 to 74, wherein the distance between the adjacent aperture surfaces is small, desirably so that the difference in beam energy between the facing aperture surfaces is small.

## Claims

1. A charged particle-optical device comprising:

   a lens array configured to focus a plurality of charged particle beams in a beam grid towards a sample position;
   a corrector comprising at least two aperture arrays in which are defined corresponding arrays of apertures each having an aperture pattern, the at least two aperture arrays comprising one or more pairs of facing aperture surfaces of adjacent aperture arrays, each pair of facing aperture surfaces corresponding to a species of correction for a respective aberration of the beam grid, the aperture pattern defined in at least one of the facing aperture surfaces of the pair being configured to apply the respective species of correction to the beam grid; and
   a voltage supply configured to apply a potential difference between the or each pair of facing aperture surfaces to cause the respective species of correction to be applied to the beams of the beam grid, the applied potential difference selectable to define a magnitude of the respective species of correction substantially independently of focusing of the beam grid at a sample position.

2. The device of claim 1, wherein the or each pair of facing aperture surfaces is configured to have a focusing strength when applying the respective species of correction that is substantially weaker than lenses of the lens array.

3. The device of claim 1 or 2, wherein the or each pair of facing aperture surfaces is configured such that a lensing effect of the facing aperture surfaces of the pair substantially cancels apart from applying the respective species of correction to the beams of the beam grid.

4. The device of any preceding claim, wherein the voltage supply is configured to apply a compensating potential difference between compensating aperture facing surfaces of aperture arrays outside of the corrector, the compensating potential difference configured to at least partially compensate a common focusing effect applied by the corrector while the corrector applies one or more of the species of correction, the common focusing effect being a focusing effect common to all beams of the beam grid, optionally, wherein the voltage supply is configured to vary the applied compensating potential difference as a function of the magnitude or magnitudes of respective species of correction applied by the corrector.

5. The device of any preceding claim, wherein, for at least one of the pairs of facing aperture surfaces, the aperture pattern in at least one of the facing aperture surfaces has a perturbed form,

6. The device of any preceding claim, wherein the lens array comprises a plurality of lens aperture array surfaces arranged in series along beam paths of the charged particle beams of the beam grid.

7. The device of claim 6, wherein a separation between two adjacent lens aperture array surfaces of the lens array is larger than a distance between the facing aperture surfaces of at least one of the pairs of facing aperture surfaces of the corrector, desirably at least 2 times larger and/or no more than 50 times larger.

8. The device of any preceding claim, wherein the corrector comprises a plurality of the pairs of facing aperture surfaces and each pair is configured to apply a different respective species of correction to the beam grid, optionally wherein each pair is configured to be controllable separately from the other pairs, for example to separately define the magnitude of the respective species of correction.

9. The device of any preceding claim, wherein the or each species of correction is configured to correct a beam property of beams on a macroscopic scale across the beam grid, the beam property desirably including one or more of: beam focus; beam astigmatism, beam positioning.

10. The device of any preceding claim, wherein each of one or more of the aperture arrays of the corrector is configured to be controllable via a single electrical connection to the aperture array, desirably controllable to apply a potential to a facing aperture surface defined by the aperture array for applying one of the species of correction.

11. The device of any preceding claim, wherein the voltage supply is configured to vary the magnitude of at least one of the species of correction over a respective correcting range, desirably a limit of the correcting range being substantially zero.

12. The device of any preceding claim, wherein at least one of the aperture arrays of the corrector is adjacent to another charged particle-optical element different from the corrector, the other charged particle-optical element being the lens array or a deflector, such as a deflector array, that is adjacent to the lens array.

13. The device of any preceding claim, wherein the lens array comprises or consists of an objective lens array., wherein the corrector is outside of the objective lens array.

14. The device of any preceding claim, wherein the voltage supply is configured to:

control the lens array to selectively vary a beam current of the beams of the beam grid at the sample by changing a magnification of the charged particle-optical device; and use the corrector to compensate for macro aberrations caused by the change in magnification by applying one or more of the species of correction to the beams of the beam grid.

15. A method of projecting a plurality of charged particle beams towards a sample, comprising:

using a lens array to focus a plurality of charged particle beams in a beam grid towards a sample; applying a potential difference between a pair of facing aperture surfaces of a corrector to apply a species of correction to the beam grid, the species of correction defined by an aperture pattern, wherein: the magnitude of the applied species of correction is selectable independently of focusing of the beam grid on the sample.

# Fig. 1

# Fig. 2

# Fig. 3

# Fig. 4

# Fig. 5

# Fig. 6

801

802

802

# Fig. 7

801

802

802

# Fig. 8

# Fig. 9

# Fig. 10

# Fig. 11

# Fig. 12

# Fig. 13

# Fig. 14

# Fig. 15

# Fig. 16

# Fig. 17

40

614

610

610

601

510

250

260

241

208

# Fig. 18

40

250

510

614

601

610

610

500

260

241

208

500

# Fig. 19

# Fig. 20

Europäisches Patentamt

European Patent Office

Office européen des brevets

# EUROPEAN SEARCH REPORT

**Application Number**

EP 23 21 7694

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 4 250 331 A1 (ASML NETHERLANDS BV [NL]) 27 September 2023 (2023-09-27) * paragraph [0015]; figure 8 * | 1-14 | INV. H01J37/153 |
| X,D | WO 2022/101072 A1 (ASML NETHERLANDS BV [NL]) 19 May 2022 (2022-05-19) * paragraph [0130]; figures 20,21 * | 1-15 | |

**TECHNICAL FIELDS SEARCHED (IPC)**

H01J

The present search report has been drawn up for all claims

| Place of search | Date of completion of the search | Examiner |
|---|---|---|
| Munich | 31 May 2024 | Oestreich, Sebastian |

EPO FORM 1503 03.82 (P04C01)

## ANNEX TO THE EUROPEAN SEARCH REPORT
## ON EUROPEAN PATENT APPLICATION NO.

EP 23 21 7694

This annex lists the patent family members relating to the patent documents cited in the above-mentioned European search report.
The members are as contained in the European Patent Office EDP file on
The European Patent Office is in no way liable for these particulars which are merely given for the purpose of information.

31-05-2024

| Patent document cited in search report | | Publication date | Patent family member(s) | | Publication date |
|---|---|---|---|---|---|
| EP 4250331 | A1 | 27-09-2023 | EP | 4250331 A1 | 27-09-2023 |
| | | | EP | 4250332 A1 | 27-09-2023 |
| | | | WO | 2023180016 A1 | 28-09-2023 |
| WO 2022101072 | A1 | 19-05-2022 | CA | 3198634 A1 | 19-05-2022 |
| | | | EP | 4244881 A1 | 20-09-2023 |
| | | | IL | 302654 A | 01-07-2023 |
| | | | JP | 2023548663 A | 20-11-2023 |
| | | | KR | 20230098813 A | 04-07-2023 |
| | | | TW | 202226302 A | 01-07-2022 |
| | | | US | 2023290609 A1 | 14-09-2023 |
| | | | WO | 2022101072 A1 | 19-05-2022 |

EPO FORM P0459

For more details about this annex : see Official Journal of the European Patent Office, No. 12/82

## REFERENCES CITED IN THE DESCRIPTION

**Patent documents cited in the description**

- EP 2425444 A
- EP 3869535 A1
- WO 2022101072 A1